(19) Europäisches Patentamt
European Patent Office
Office européen des brevets

(11) EP 3 076 775 A1

(12) # EUROPEAN PATENT APPLICATION
published in accordance with Art. 153(4) EPC

(43) Date of publication:
**05.10.2016 Bulletin 2016/40**

(21) Application number: **14864690.4**

(22) Date of filing: **21.11.2014**

(51) Int Cl.:
***H05K 9/00*** (2006.01) ***B32B 5/08*** (2006.01)
***D04H 3/16*** (2006.01)

(86) International application number:
**PCT/JP2014/080963**

(87) International publication number:
**WO 2015/076387 (28.05.2015 Gazette 2015/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.11.2013 JP 2013243288**

(71) Applicant: **ASAHI KASEI KABUSHIKI KAISHA**
**Tokyo 101-8101 (JP)**

(72) Inventors:
- **TANAKA, Tomoya**
  **Tokyo 101-8101 (JP)**
- **OKAMURA, Chie**
  **Tokyo 101-8101 (JP)**
- **OKAJIMA, Shinichi**
  **Tokyo 101-8101 (JP)**
- **KAWAMURA, Tomoyuki**
  **Tokyo 101-8101 (JP)**
- **KATO, Kazufumi**
  **Tokyo 101-8101 (JP)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **NOISE-ABSORBING SHEET**

(57) Provided is a noise-absorbing sheet that is highly effective at absorbing noise from magnetic and/or electric fields, the noise-absorbing effect being effective in wider bandwidths. A noise-absorbing sheet upon which at least two layers are stacked, wherein the noise absorbing sheet is characterized in that a magnetic layer containing a magnetic material and a layer of a noise-absorbing fabric in which a metal is deposited on constituent fibers are layered on said sheet, and the common logarithmic value of the surface resistivity of at least one side of the noise-absorbing fabric is 0 to 6.

FIG. 1

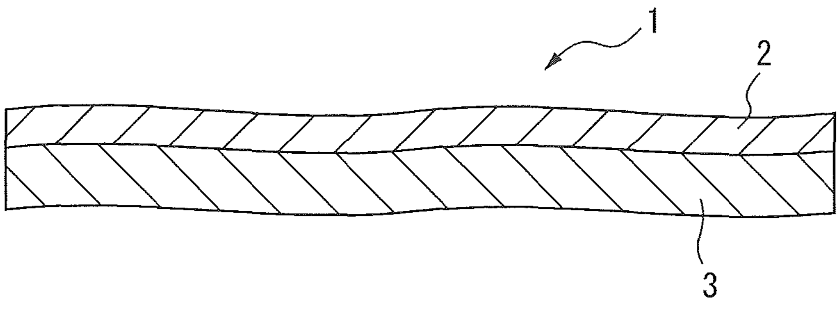


EP 3 076 775 A1

## Description

### TECHNICAL FIELD

The present invention relates to a noise-absorbing sheet capable of absorbing conduction noise and radiation noise in electronic devices, and capable of effectively absorbing radiation noise in high-frequency bands in particular.

### BACKGROUND ART

Accompanying the full-scale proliferation of electronic devices such as large-screen televisions and wireless communication devices such as cell phones and wireless LAN, the amount of information handled by these devices has increased remarkably. Consequently, these electronic devices and wireless communication devices are being increasingly required to demonstrate higher capacities, higher degrees of integration and faster communication speeds at higher processing speeds and with greater transmission efficiency. In order to satisfy these requirements, LSI clock frequencies and transmission frequencies used in electronic devices are shifting to higher frequencies and the frequencies at which communication devices are used are also becoming higher.

As a result of these higher frequencies, malfunctions have been reported to occur more easily in other devices due to noise generated from electronic devices, and problems have also been reported to occur easily in electronic devices and communications that are caused by interference with electromagnetic waves used in communication devices.

Consequently, there has been a growing need for so-called electromagnetic compatibility (EMC) countermeasures in the form of noise absorbers that absorb the noise generated from electronic devices for the purpose of preventing interference from electromagnetic waves in electronic devices, transmission lines and communication systems.

Moreover, during the course of transitioning to a ubiquitous society, the number of mobile personal computers is increasing and cell phones are becoming more compact and offering higher levels of performance. Thus, there is a desire for devices and materials that enable reductions in size and weight. In particular, there has been considerable proliferation of devices installed with wireless communication antennas as represented by Wi-Fi and GPS, and in these devices, noise generated by the devices per se cause interference with the wireless communications antenna resulting in problems that exacerbate communication status and give rise to so-called self-interference, thereby resulting in the need for higher levels of noise countermeasures.

A noise-absorbing sheet in which a soft magnetic body is dispersed in a resin is disclosed and applied practically in Patent Document 1 indicated below. The principle behind the performance demonstrated by the aforementioned noise-absorbing sheet is such that the soft magnetic body dispersed in the resin undergoes magnetic polarization as a result of capturing electromagnetic waves, and the electromagnetic waves are then converted to thermal energy due to the loss of magnetism at that time. Although the aforementioned soft magnetic body is effective on magnetic field components of noise, it does not demonstrate prominent absorbing effects on electric field components.

In addition, although noise-absorbing sheets using a soft magnetic body demonstrate effects in the MHz band based on the properties of soft magnetic bodies, they have little noise-absorbing effects on higher frequency components such as those of the GHz band. Although attempts have been made to enhance performance in higher frequency bands by controlling magnetism by using a powder having a complex soft magnetic body composition and structure for the noise-absorbing sheet, such as by using rare metals and/or trace elements for the material of the soft magnetic body to obtain a more complex compound, this results in problems in terms of cost.

Moreover, although noise-absorbing sheets having a soft magnetic body dispersed in a resin absorb noise of a specific frequency, they have difficulty in absorbing broad-band noise. Consequently, although studies have been conducted in which particles demonstrating effects against various frequencies are mixed and formed into a sheet, since there are limitations on the amount of particles that can be added to form the sheet, it was difficult to demonstrate the ability to absorb noise over a broad frequency band.

On the other hand, a noise-absorbing fabric having metals coated on a fabric has been proposed for use as a noise-absorbing sheet that is effective over a wide frequency band (refer to Patent Document 2 indicated below). Although this noise-absorbing fabric is highly effective for eliminating noise consisting of electric field noise, noise-absorbing effects against magnetic field components do not reach the level of the aforementioned noise-absorbing sheet having a soft magnetic body dispersed in resin.

In addition, although a noise-absorbing sheet has been developed that compounds a so-called electromagnetic shielding body such as metal foil or metal-processed fabric with a noise-absorbing sheet in which a soft magnetic body has been dispersed in a resin in order to impart an effect on electric field noise components (refer to Patent Documents 3 and 4 indicated below), since the electromagnetic shielding sheet has extremely high conductivity, many of the components are reflected and noise absorption performance ends up decreasing. In addition, since the electromagnetic shielding body per se acts as an antenna, it has the potential to cause secondary noise radiation, thereby having an unexpected detrimental effect on electronic devices.

Moreover, although a noise-absorbing sheet has been proposed that reduces reflection of electromagnetic waves as described above by superimposing a layer obtained by dispersing a soft magnetic body in a resin on an electromagnetic wave-absorbing film composed of a plastic film processed with metal or carbon nanotubes instead of the aforementioned electromagnetic shielding body (refer to Patent Document 5 indicated below), the processing steps of this electromagnetic wave-absorbing film become complex in order to demonstrate the electromagnetic wave-absorbing performance thereof. In addition, since materials are expensive, product cost ends up becoming extremely high. In addition, with respect to noise absorption performance as well, since the noise absorption performance of the plastic film and magnetic layer are merely added, a dramatic improvement in noise-absorbing effects is not observed.

Prior Art Documents

Patent Documents

[Patent Document 1] Japanese Unexamined Patent Publication No. 2012-28576
[Patent Document 2] Japanese Unexamined Patent Publication No. 2011-146696
[Patent Document 3] Japanese Unexamined Patent Publication No. H7-212079
[Patent Document 4] Japanese Unexamined Patent Publication No. 2005-327853
[Patent Document 5] International Publication No. WO 2013/081043

DISCLOSURE OF THE INVENTION

Problems to be Solved by the Invention

As has been described above, conventional noise-absorbing sheets demonstrated limited effects depending on the type of noise component or frequency component, or did not demonstrate adequate noise absorption performance due to the large number of reflected components. Thus, an object of the present invention is to provide a noise-absorbing sheet that demonstrates highly effective noise absorption against both magnetic field noise and electric field noise and demonstrates effective noise-absorbing effects over a wider bandwidth.

Means for Solving the Problems

As a result of conducting extensive studies to solve the aforementioned problems, the inventors of the present invention found that, by compounding a layer composed of a magnetic material, which is highly effective for magnetic field noise components, and a noise-absorbing fabric layer obtained by coating a metal onto a fabric, which is highly effective for electric field noise components, highly effective noise absorption is demonstrated against each noise component due to the synergistic effect of each sheet while also having a low level of reflected components, thereby leading to completion of the present invention.
More specifically, the present invention provides the inventions indicated below.
1. A noise-absorbing sheets comprising the lamination of at least two layers, wherein a magnetic layer containing a magnetic material and a noise-absorbing fabric layer having a metal adhered to constituent fibers, are laminated, and the common logarithmic value of the surface resistivity on at least one side of the noise-absorbing fabric is within the range of 0 to 6.
2. The noise-absorbing sheet described in 1 above, wherein the fabric is a nonwoven fabric composed of synthetic long fibers.
3. The noise-absorbing fabric described in 1 or 2 above, wherein the fabric contains fibers having a fiber diameter of greater than 7.0 μm to 50 μm.
4. The noise-absorbing sheet described in any of 1 to 3 above, wherein the fabric contains fibers having a fiber diameter of 7.0 μm or less.
5. The noise-absorbing sheet described in 4 above, wherein the fabric is a fabric consisting of a mixture of fibers having a diameter of greater than 7.0 μm to 50 μm and fibers having a fiber diameter of 0.01 μm to 7.0 μm.
6. The noise-absorbing sheet described in 5 above, wherein the fabric is a laminated fabric having at least two layers consisting of a first layer and a second layer, the first layer is a layer of a nonwoven fabric composed of fibers having a fiber diameter of greater than 7 μm to 50 μm, and the second layer is a layer of a nonwoven fabric composed of fibers having a fiber diameter of 0.01 μm to 7.0 μm.

7. The noise-absorbing sheet described in 6 above, wherein the fabric is a laminated fabric having at least three layers consisting of a first layer, a second layer and a third layer in that order, the first layer and the third layer are layers of a nonwoven fabric composed of fibers having a fiber diameter of greater than 7 μm to 50 μm, and the second layer is a layer of a nonwoven fabric composed of fibers having a fiber diameter of 0.01 μm to 7.0 μm.

8. The noise-absorbing sheet described in any of 1 to 7 above, wherein the thickness of the fabric is 10 μm to 400 μm and the fabric weight is 7 g/$m^2$ to 300 g/$m^2$.

9. The noise-absorbing sheet described in any of 1 to 8 above, wherein the thickness of the magnetic layer is 20 μm to 500 μm.

10. The noise-absorbing sheet described in any of 1 to 9 above, wherein the magnetic layer contains 55% by weight to 90% by weight of a metal magnetic powder and 10% by weight to 45% by weight of a binder.

11. The noise-absorbing sheet described in any of 1 to 10 above, wherein reflection loss $(S11)^2$ at 1 GHz is 0.2 or less.

12. The noise-absorbing sheet described in any of 1 to 11, wherein, in the case of defining the electric field noise-absorbing effect of the layer of the noise-absorbing fabric having metal adhered to constituent fibers as Ae, the electric field noise-absorbing effect of the magnetic layer containing a magnetic material as Be, and the electric field noise-absorbing effect of the noise-absorbing sheet as Ce, then Ae + Be > Ce.

13. The noise-absorbing sheet described in any of 1 to 12, wherein, in the case of defining the magnetic field noise-absorbing effect of the noise-absorbing fabric having metal adhered to constituent fibers as Am, the magnetic field noise-absorbing effect of the magnetic layer containing a magnetic material as Bm, and the magnetic field noise-absorbing effect of the noise-absorbing sheet as Cm, then Am + Bm > Cm.

Effects of the Invention

The noise-absorbing sheet of the present invention is resistant to reflection of electromagnetic waves while demonstrating a superior ability to absorb noise. In addition, it is also effective for wide-band noise and demonstrates highly effective noise absorption against both magnetic field and electric field noise components. In addition, the noise-absorbing sheet has superior flexibility, can be made into a thin film, and can be produced inexpensively.

## BRIEF DESCRIPTION OF THE DRAWINGS

FIG. 1 is a drawing schematically showing a cross-section of the noise-absorbing sheet of the present invention.
FIG. 2 is a drawing schematically showing a cross-section of a magnetic layer used in the present invention.
FIG. 3 is a drawing schematically showing a cross-section of the noise-absorbing fabric layer used in the present invention.
FIG. 4 is a drawing for explaining a conductivity gradient of a noise-absorbing fabric layer.
FIG. 5 is a drawing for explaining metal clusters in a noise-absorbing fabric layer.
FIG. 6 is a schematic diagram showing one mode of the laminated state of metal particles on fibers.
FIG. 7 is a drawing for explaining the microstrip line method.
FIG. 8 is a drawing for explaining a method for measuring noise level.
FIG. 9 indicates the results of measuring magnetic field noise in Example 1.
FIG. 10 indicates the results of measuring electric field noise in Example 1.
FIG. 11 indicates the results of measuring magnetic field noise in Example 2.
FIG. 12 indicates the results of measuring electric field noise in Example 2.
FIG. 13 indicates the results of measuring magnetic field noise in Comparative Example 1.
FIG. 14 indicates the results of measuring electric field noise in Comparative Example 1.
FIG. 15 indicates the results of measuring magnetic field noise in Comparative Example 2.
FIG. 16 indicates the results of measuring electric field noise in Comparative Example 2.
FIG. 17 indicates the results of measuring magnetic field noise in Comparative Example 3.
FIG. 18 indicates the results of measuring electric field noise in Comparative Example 3.
FIG. 19 indicates the results of measuring according to the microstrip line method in Example 1.
FIG. 20 indicates the results of measuring according to the microstrip line method in Example 2.
FIG. 21 indicates the results of measuring according to the microstrip line method in Comparative Example 9.
FIG. 22 is a drawing showing a board used to measure electric field distribution mapping.
FIG. 23 indicates the results of measuring electric field mapping in a blank state (absence of a sheet).
FIG. 24 indicates the results of measuring electric field mapping in Example 1.
FIG. 25 indicates the results of measuring electric field mapping in Comparative Example 9.

BEST MODE FOR CARRYING OUT THE INVENTION

The following provides a detailed explanation of the noise-absorbing sheet of the present invention using drawings.

FIG. 1 is a drawing schematically showing a cross-section of the noise-absorbing sheet of the present invention. The noise-absorbing sheet (1) of FIG. 1 has a magnetic layer (2) containing a magnetic material and a noise-absorbing fabric layer (3) having a metal adhered to constituent fibers thereof.

FIG. 2 is a drawing schematically showing a cross-section of a magnetic layer containing a magnetic material that composes the noise-absorbing sheet of the present invention. The magnetic layer of FIG. 2 is composed of magnetic body particles (4) and a binder (5) for retaining them. In FIG. 2, although all of the magnetic body particles are drawn circular for the sake of convenience, there are no particular limitations on the shape of the magnetic body particles.

FIG. 3 is an enlarged schematic diagram of a cross-section of one mode of the noise-absorbing fabric layer that composes the noise-absorbing sheet of the present invention. The noise-absorbing fabric layer of FIG. 3 is composed of a metal-processed fabric, and a metal (6) is formed on fibers (7) that compose the fabric. Furthermore, in FIG. 3, the cross-sections of the fibers are all drawn circular for the sake of convenience.

In the present invention, the common logarithmic value of surface resistivity (Ω/□) of the processed surface of the noise-absorbing fabric layer is within the range of 0 to 6 and preferably within the range of 0 to 4. The common logarithmic value of surface resistivity refers to the value of $\log_{10}X$ in the case of defining surface resistivity as X (Ω/□). If the common logarithmic value of surface resistivity is less than 0, conductivity becomes excessively large, the majority of electromagnetic waves are reflected from the aforementioned surface of the noise-absorbing fabric, or more precisely, from the metal-processed surface, and the ability to absorb noise becomes inferior. In the case conductivity is low and reflection of electromagnetic waves is large, electromagnetic waves interfere with each other and noise absorption is impaired.

On the other hand, if the aforementioned common logarithmic value of surface resistivity exceeds 6, electromagnetic waves may permeate the noise-absorbing fabric layer resulting in an inferior ability to absorb (capture) electromagnetic waves. In the case the common logarithmic value of surface resistivity is within the range of 0 to 6, electromagnetic waves suitably enter the interior of the noise-absorbing fabric layer of the present invention and the electromagnetic waves that have entered are captured by the processed metal where they are converted to electricity, and since they are further converted to thermal energy by electrical resistance, the ability to absorb noise becomes high. The aforementioned common logarithmic value of surface resistivity of the noise-absorbing fabric layer is more preferably within the range of 0.1 to 3.

The aforementioned surface resistivity can be measured according to the four-terminal method using the Model MCP-T600 Loresta-GP Low Resistance Meter manufactured by Mitsubishi Chemical Corp.

The interior of the noise-absorbing fabric layer preferably has lower conductivity than the metal-processed surface. One example of a means for making the conductivity of the interior lower than the conductivity of the metal-processed surface consists of making the ratio of metal to the total weight of metal inside the noise-absorbing fabric layer and the fabric lower than the ratio of metal on the metal-processed surface. FIG. 4 is a drawing for explaining a conductivity gradient of the noise-absorbing fabric layer of the present invention. The noise-absorbing fabric shown in FIG. 4 contains a fabric formed from the fibers (7) and the processed metal (6). In FIG. 4, the ratio of metal to the total weight of the metal inside the noise-absorbing fabric (bottom portion in the drawing) and the fabric is lower than the ratio of metal to the total weight of the metal on the surface of the noise-absorbing fabric (top portion in the drawing) and the fabric. Thus, the noise-absorbing fabric shown in FIG. 4 has lower conductivity on the inside than on the surface thereof.

Furthermore, in FIG. 4, the cross-sections of all fibers are represented with circles for the sake of convenience. In addition, in the present description, "conductivity" refers to the degree of conductivity.

Although electromagnetic waves that have entered from the outside are captured by a portion having high conductivity and then converted to electricity due to the presence of a suitable conductivity gradient, since conductivity is smaller the farther to the inside of the fabric in particular, or in other words, since the value of electrical resistance is large, electrical energy is easily converted to thermal energy by electrical resistance. As a result, electromagnetic waves are efficiently absorbed and noise can be efficiently absorbed.

The aforementioned conductivity gradient can be achieved by, for example, performing metal processing according to a metal deposition method to be subsequently described.

Although at least one side of the noise-absorbing fabric is subjected to metal processing, metal processing may also be performed on both sides of the fabric.

In a noise-absorbing fabric in which both sides thereof have been subjected to metal processing, conductivity inside the fabric is preferably lower than conductivity on a metal-processed surface on at least one side thereof, and electrical conductivity inside the fabric is more preferably lower than electrical conductivity on both of the metal-processed surfaces.

In the present invention, the base material in the noise-absorbing fiber layer consists of a fabric in the form of a fiber assembly. As a result of employing a fabric for the base material, the base material has greater pliability, has ample flexibility, and in the case of incorporating in an electronic device, allows more complex shapes to be used, thereby enabling it to be arranged at locations where noise is generated by highly integrated electronic components present in the cabinets of electronic devices.

Furthermore, in the present description, simply referring to a "fabric" refers to a fabric that has not undergone metal processing, while referring to a "noise-absorbing fabric" refers to a metal-processed fabric.

In addition, by employing a fabric in the form of a fiber assembly for the base material, the processed metal is able to contain a plurality of metal clusters. FIG. 5 is a drawing for explaining metal clusters, and metal clusters (8) are formed on the fibers (7) that compose the fabric. FIG. 6 is a schematic diagram showing one mode of the laminated state of metal particles on fibers in the case of having performed metal processing by a metal deposition method to be subsequently described. The noise-absorbing fabric shown in FIG. 6 contains a fabric and a processed metal, and the processed metal is composed of the metal clusters (8). Each metal cluster (8) has a different electrical resistance value and may have a switching effect resulting in higher ability to absorb noise.

Furthermore, in FIG. 6, the cross-sections of all fibers are represented with circles in the same manner as FIG. 4.

The selection of a fabric in the form of a fiber assembly for the base material of the noise-absorbing fabric results in an increase in the number of entanglement points, thereby making it possible to demonstrate higher performance.

In addition, since the surface of the fabric is not smooth, in the case of performing metal processing by metal deposition and the like from one direction, a plurality of metal clusters are formed, and electrical resistance values differ depending on the location from the microscopic point of view. Thus, electromagnetic waves that have entered from the outside are captured by the metal clusters having sufficient conductivity and electrical resistance values where they are converted to electricity and subsequently converted to thermal energy by electrical resistance, thereby demonstrating noise absorption. This point differs considerably from conventional films and sheets having smooth surfaces. Namely, in the case of having subjected the smooth surface of a film or sheet and the like to metal processing by metal deposition and the like, the metal-processed surface becomes smoother, the large conductivity inherently possessed by the metal ends up being demonstrated, or in other words, the common logarithmic value of surface resistivity easily becomes less than zero, and there is greater susceptibility to reflection of electromagnetic waves. In addition, it is difficult to process the surface of a film or sheet nonuniformly, and processing nonuniformly results in problems in terms of cost.

Since the fabric used in the present invention consists of a fiber assembly, has numerous entangled points between fibers, and the surface thereof is not uniform (has curvature when viewed from a single direction), when subjected to metal processing by metal deposition and the like, metal clusters are formed that are more electrically non-uniform, and since electromagnetic waves that have been captured are more efficiently consumed by electrical resistance, the noise-absorbing fabric used in the present invention is able to demonstrate an extremely high ability to absorb noise.

The fabric used in the present invention is preferably a nonwoven fabric, and the fibers that compose the fabric are preferably synthetic long fibers.

In general, fabrics such as woven fabrics or knit fabrics have a high ratio of fibers oriented in the longitudinal or lateral direction of the fabric. In this case, the noise-absorbing fabric obtained by performing metal processing on the fabric also has the metal oriented in a fixed direction, and the noise absorption thereof has a fixed directivity. Thus, in the case noise is derived from a fixed direction, a fabric having fibers oriented in a fixed direction, such as a woven fabric or knit fabric, is preferable. On the other hand, in the case noise is derived from various directions in the manner of typical electronic devices, a fabric in which the fibers are not oriented in a fixed direction, such as a nonwoven fabric, is preferable.

In addition, the fibers not being oriented in a fixed direction suppresses reflection and makes it possible to demonstrate higher noise absorption. Thus, the fabric used in the present invention is more preferably a nonwoven fabric.

In addition, in the case of using in an electronic device, the noise-absorbing sheet of the present invention is frequently used by being stamped out into a complex shape according to the shape of an electronic component or circuit line and the like and affixed to an electronic component or transmission line or affixed to the cabinet of an electronic component. In the case the fabric used in the noise-absorbing sheet is a woven fabric or knit fabric and the like, in the case of having stamped out into a complex shape, there are cases in which fiber fragments are formed on the edges of stamped out portions. Since the aforementioned fiber fragments may be formed in conjunction with processed metal, there is the risk of short-circuiting and erroneous operation of an electronic component.

The fabric used in the present invention is more preferably a fabric fabricated by heat. When a fabric is produced by adding a binder, the binder may migrate to an electronic device and cause an erroneous operation. Thus, the fabric is preferably a synthetic long fiber nonwoven fabric that is fabricated by heat without using a binder. On the other hand, from the viewpoint of rationality of the process used to produce the fabric, costs can be further reduced by being able to fabricate the fabric by heat, thereby making this preferable.

In the present invention, the fibers that compose the fabric are preferably synthetic fibers that allow the fabric to be fabricated by heat. In addition, cellulose-based fibers such as pulp or rayon fibers may easily contain moisture due to their hydrophilicity. The re-release of the contained moisture leads to erroneous operation of an electronic device, thereby making this undesirable.

Specific examples of fibers that compose the fabric used in the present invention include fibers composed of polyolefins such as polypropylene or polyethylene, polyalkylene terephthalate resins (such as PET, PBT or PTT) and derivatives thereof, polyamide-based resins and derivatives thereof such as N6, N66 of N612, polyoxymethylene ether-based resins (such as POM), PEN, PPS, PPO, polyketone resin and polyketone-based resins such as PEEK or thermoplastic polyimide resins such as TPI, and fibers formed from combinations thereof.

Although the aforementioned fibers can be suitably selected corresponding to the environment in which the noise-absorbing fabric of the present invention is applied, they can also be selected, for example, in the manner indicated below.

Since polyamide-based resins such as N6, N66 or N612 and derivatives thereof are highly water-absorbent fibers, it is preferable to avoid their use in electronic components that are extremely sensitive to moisture in comparison with other resins. In the case of the need for heat resistance of solder or in cases in which there is the potential for the occurrence of problems caused by heat generated from an electronic component and the like, namely in electronic devices requiring heat resistance, a resin formed from a PET-based resin, PPS-based resin or PEEK-based resin is used preferably. On the other hand, polyolefin resin, PET-based resin, PPS-based resin, PPO-based resin, PEEK-based resin and fluorine-based resin are preferable in consideration of electrical properties such as dielectric constant or tan$\delta$.

The aforementioned fibers are preferably flame-retardant fibers. This is because fibers that do not burn easily when ignited should be used from the viewpoint of the safety of electronic devices.

Although varying according to the environment in which the noise-absorbing sheet of the present invention is used, the fiber diameter of the aforementioned fibers is preferably 50 $\mu$m or less. This is because this allows the obtaining of a fabric having a uniform inter-fiber distance, making it possible to reduce permeation or other leakage of electromagnetic waves. In addition, since the fibers have high strength resulting in a low possibility of the fabric or noise-absorbing fabric tearing in the metal processing step or the environment in which the fabric is used, the fabric can be stably processed and used.

In the noise-absorbing sheet of the present invention, the fabric preferably contains a layer of fibers having a fiber diameter of 7 $\mu$m or less (to also be referred to as "ultrafine fibers"). As a result of containing a layer of ultrafine fibers having a fiber diameter of 7 $\mu$m or less, the number of fibers per unit volume increases and the specific surface area of the fibers becomes larger, and as a result thereof, the specific surface area of the metal layer also increases resulting in higher ability to absorb noise. In addition, as a result of containing a layer of ultrafine fibers, the thickness of the noise-absorbing fabric is reduced, thereby making this preferable for use in electronic devices designed for light weight, reduced thickness, short length and compact size. In addition, reducing the thickness of the noise-absorbing sheet of the present invention enables the sheet to be bent easily, which similarly facilitates installation in electronic devices while also making it easier to demonstrate a higher ability to absorb noise. The fabric used in the present invention preferably contains a layer of fibers having a fiber diameter of 7 $\mu$m or less, and more preferably contains a layer of fibers having a fiber diameter of 4 $\mu$m or less.

The fiber diameter of the aforementioned ultrafine fibers is preferably 0.01 $\mu$m or more and more preferably 0.05 $\mu$m or more.

The aforementioned ultrafine fibers are preferably produced by a method such as melt blowing or electrospinning, and are more preferably produced by melt blowing.

In addition, as was previously described, in the noise-absorbing fabric used in the present invention, the fibers are preferably not oriented in a fixed direction, but rather have a random orientation.

In the case of a fabric composed of ultrafine fibers, since fabric strength tends to be low, there are cases in which it is preferable to use in combination with a fabric containing fibers having a larger fiber diameter than the ultrafine fibers, namely fibers having a fiber diameter of greater than 7 $\mu$m (to also be referred to as "ordinary fibers").

Although there are no particular limitations on the cross-sectional shape of the fibers that compose the fabric used in the present invention, in order to form a less uniform surface, the fibers are preferably modified cross-section yarn or split fiber yarn and the like. In addition, crimped yarn or twisted yarn can also be used for the same purpose.

Although there are no particular limitations thereon, the tensile strength of the fabric used in the present invention is preferably 10 N/3 cm or more in consideration of such factors as metal processing steps and handling when using the noise-absorbing fabric. If the aforementioned tensile strength is 10 N/3 cm or more, there is less susceptibility of the occurrence of fabric tearing or wrinkling in metal processing steps such as vacuum deposition or sputtering, while also allowing the production of a noise-absorbing fabric that is free of problems during use. The aforementioned tensile strength is more preferably 20 N/3 cm or more.

Furthermore, the aforementioned tensile strength refers to the value measured in accordance with JIS-L1906:2000 5.3 with the exception of using a value of 3 cm for the width of the test piece.

The thickness of the fabric used in the present invention is preferably within the range of 10 $\mu$m to 400 $\mu$m, and more preferably within the range of 15 $\mu$m to 200 $\mu$m. If the aforementioned fabric thickness is less than 10 $\mu$m,

the fabric does not have suitable strength or stiffness during metal processing, which may make metal processing difficult, and the metal may pass through the back of the fabric and contaminate the apparatus during metal processing. Moreover, there are cases in which the strength of a stamped out noise-absorbing fabric may be weak. In addition, if the aforementioned fabric thickness exceeds 400 μm, the fabric may have excessive stiffness during metal processing. Moreover, if the noise-absorbing sheet of the present invention is excessively thick, it may be difficult to insert into narrow locations, difficult to bend, difficult to fold or difficult to install in an electronic component.

The aforementioned fabric thickness can be measured in accordance with the method defined in JIS-L-1906:2000.

The fabric weight used in the present invention is preferably within the range of 7 g/$m^2$ to 300 g/$m^2$ and more preferably within the range of 15 g/$m^2$ to 150 g/$m^2$. If the fabric weight is less than 7 g/$m^2$, the metal may pass through the back of the fabric during metal processing and contaminate the apparatus. Moreover, there are cases in which the strength of the noise-absorbing fabric of the present invention may be weak, making it difficult to use in steps such as processing or stamping. If the fabric weight exceeds 300 g/$m^2$, the noise-absorbing fabric of the present invention may be excessively heavy. In the case the fabric weight is within the range of 7 g/$m^2$ to 300 g/$m^2$, the noise-absorbing fabric of the present invention is able to maintain its shape and have favorable handling.

The aforementioned fabric weight can be measured in accordance with the method defined in JIS L-1906:2000.

The fabric used in the present invention preferably has an average opening size of 0.05 μm to 5.0 μm. If the average opening size is not excessively small, there are a suitably large number of entangled points between fibers and noise absorption performance can be enhanced due to switching effects. In addition, in the case average opening size is not excessively large, the gaps between fibers are not excessively large and it becomes easy to obtain a target electrical resistance value during metal processing. Moreover, the average opening size is preferably 0.05 μm to 1.0 mm, more preferably 0.05 μm to 500 μm, even more preferably 0.5 μm to 200 μm, and most preferably 0.5 μm to 30 μm. The aforementioned average opening size can be measured with a Perm Porometer.

There are no particular limitations on the method used to produce the fabric used in the present invention, and the fabric used in the present invention can be produced by a method used to produce ordinary woven fabrics, knit fabrics or nonwoven fabrics. In the case the fabric used in the present invention is a nonwoven fabric, a method used to produce synthetic long fiber nonwoven fabric such as spun bonding, melt blowing or flash spinning is preferable. In addition, in the case the fabric used in the present invention is a nonwoven fabric, a method using short fibers such as papermaking or dry methods can also be used. In the case the fabric used in the present invention is a nonwoven fabric, a method for producing nonwoven fabric using synthetic fibers is more preferable, and this allows a noise-absorbing fabric to be produced that has high strength and is easily processed.

In addition, the fabric used in the present invention is preferably a laminated nonwoven fabric formed by laminating a layer of a nonwoven fabric composed of ultrafine fibers and a layer of a nonwoven fabric composed of ordinary fibers. The aforementioned ultrafine fibers and ordinary fibers are preferably composed of a thermoplastic resin, and tensile strength and bending flexibility of the laminated nonwoven fabric can be maintained and heat resistance stability can be maintained by integrating the layer of nonwoven fabric composed of ultrafine fibers and the layer of nonwoven fabric composed of ordinary fibers by thermal embossing. An example of the aforementioned laminated nonwoven fabric is produced by respectively laminating a spun-bonded nonwoven fabric layer and a melt-blown nonwoven fabric layer, or a spun-bonded nonwoven fabric layer, a melt-blown nonwoven fabric layer and a spun-bonded nonwoven fabric layer, in that order followed by compression bonding with embossing rollers or hot press rollers.

The aforementioned laminated nonwoven fabric is obtained by spinning at least one layer of a spun-bonded nonwoven fabric on a conveyor using a thermoplastic synthetic resin, and spraying at least one layer of a nonwoven fabric composed of ultrafine fibers having a fiber diameter of 0.01 μm to 0.7 μm thereon by melt blowing using a thermoplastic synthetic resin. Subsequently, the laminated nonwoven fabric is preferably produced by integrating into a single unit by thermocompression bonding using embossing rollers or flat rollers.

Moreover, the laminated nonwoven fabric is more preferably produced by laminating at least one layer of a thermoplastic synthetic long fiber nonwoven fabric onto a melt-blown nonwoven fabric using a thermoplastic synthetic resin prior to thermocompression bonding, and then integrating into a single unit by compression bonding using embossing rollers or flat rollers.

In the aforementioned laminated nonwoven fabric, since a layer of a nonwoven fabric composed of ultrafine fibers obtained by melt blowing is sprayed directly onto a layer of a nonwoven fabric composed of thermoplastic synthetic long fibers obtained by spun bonding, the ultrafine fibers obtained by melt blowing are able to penetrate into the layer of the nonwoven fabric composed of thermoplastic synthetic long fibers, and are able to fill in the fiber gaps of the layer of the nonwoven fabric composed of thermoplastic synthetic long fibers. As a result thereof, since the ultrafine fibers obtained by melt blowing are immobilized by penetrating into the nonwoven fabric composed of thermoplastic synthetic long fibers, not only is the structural strength per se of the laminated nonwoven fabric improved, but since the layer of nonwoven fabric composed of ultrafine fibers is resistant to movement by an external force, it is difficult for delamination to occur. Production methods of the aforementioned laminated nonwoven fabric are disclosed in, for example, International Publication No. WO 2004/94136 and International Publication No. WO 2010/126109.

In the case of a laminated nonwoven fabric obtained by laminating a spun-bonded nonwoven fabric layer and a melt-blown nonwoven fabric layer, the combined basis weight of the spun-bonded nonwoven fabric layers on the top and bottom is preferably 1.0 $g/m^2$ to 270 $g/m^2$, the fabric weight of the melt-blown nonwoven fabric layer is preferably 0.3 $g/m^2$ to 270 $g/m^2$, and the total weight of the entire laminated nonwoven fabric is preferably 7 $g/m^2$ to 300 $g/m^2$ for both a three-layer laminated nonwoven fabric and two-layer laminated nonwoven fabric. The combined fabric weight of the spun-bonded nonwoven fabric layers on the top and bottom is more preferably 3.0 $g/m^2$ to 100 $g/m^2$, the fabric weight of the melt-blown nonwoven fabric layer is more preferably 0.5 $g/m^2$ to 120 $g/m^2$, and the fabric weight of the entire laminated nonwoven fabric is more preferably 15 $g/m^2$ to 150 $g/m^2$.

In addition, the fiber diameter of fibers of the spun-bonded nonwoven fabric layer is preferably 4 $\mu$m to 50 $\mu$m, more preferably 5 $\mu$m to 40 $\mu$m and even more preferably 6 $\mu$m to 35 $\mu$m. The lower limit of fiber diameter particularly preferably exceeds 7 $\mu$m.

The fiber diameter of fibers of the melt-blown nonwoven fabric layer is preferably 7 $\mu$m or less and more preferably 4 $\mu$m or less. The fiber diameter of the melt-blown nonwoven fabric layer is preferably 0.01 $\mu$m or more and more preferably 0.05 $\mu$m or more.

The ability to absorb noise of the noise-absorbing fabric used in the present invention is clearly based on a different concept than that of the previously described prior art in that, even if the magnetic permeability of the noise-absorbing fabric used in the present invention is not that high, or in other words, does not have hardly any values of ordinary magnetic permeability, it is still able to demonstrate a high ability to absorb noise. The noise-absorbing fabric used in the present invention demonstrates the ability to absorb noise due to a conductivity gradient. As was previously described, by performing a desired metal processing on the surface of a fabric containing ultrafine fibers, the area of the metal-processed surface increases, thereby enhancing the ability to absorb noise.

In addition, the source of noise in the form of electromagnetic waves can be broadly divided into electric field components and magnetic field components (although the mechanism differs slightly between near fields and far fields), and the noise-absorbing fabric layer in the present invention demonstrates effects on electric field components in particular. Namely, the noise-absorbing fabric layer in the present invention is thought to demonstrate the ability to absorb noise due to conductive loss.

In addition, calendering treatment is preferably performed on the fabric used in the present invention in order to impart a suitable surface structure. Since calendering treatment results in the formation of surface irregularities on the surface of the fabric, the noise-absorbing fabric is able to have favorable conductivity following metal processing, and have a suitable surface resistance value. Namely, since the fabric in the form of a fiber assembly does not have as uniform a surface as a film and is flattened while retaining the shape of the fibers, the noise-absorbing fabric easily adopts a cluster structure as previously described following metal processing, thereby further enhancing the ability to absorb noise.

In the present invention, "metal processing" or "adhered with metal" refers to adhering metal, and more specifically, refers to an arbitrary treatment that enables metal to be adhered on the fabric and/or within the fabric, or depending on the case, within the fibers that compose the fabric, and examples thereof include physical metal deposition (such as vapor deposition, EB deposition, ion plating, ion sputtering, high-frequency deposition, magnetron sputtering deposition or magnetron facing target sputtering) and chemical plating (such as electroless plating or electrolytic plating). Since physical metal deposition methods consist of fine metal particles being adsorbed onto a fabric from the surface of a fabric and enable the metal deposition status to be controlled by deposition conditions, they facilitate the formation of a conductivity gradient between the surface and interior of the fabric in the noise-absorbing fabric used in the present invention. In addition, since individual fibers have a curvature on the surface thereof, when a physical metal deposition method is employed in which the particle generation source is in a single direction, it becomes easier to form suitable unevenness in the thickness of the metal on individual fibers, thereby making this preferable.

FIG. 6 is a schematic diagram showing one mode of the laminated state of metal particles on fibers obtained by metal deposition. In FIG. 6, in the case physical deposition has been performed from above in the drawing, metal particles (metal clusters (8)) are formed on the fibers (7) in a non-uniform manner. In this case, captureability of electromagnetic waves differs between thick portions and thin portions of the deposited metal, and since this captureability is not uniform when observed from the viewpoint of electrical resistance, the captured electromagnetic waves form an electrical current and are converted to thermal energy by electrical resistance when flowing through the aforementioned portions, and this is predicted to enhance the ability to absorb noise.

On the other hand, in the case of using a plating method for the aforementioned metal processing, since metal is plated over the entire fabric and metal is laminated on individual fibers quite uniformly, it is difficult to form unevenness in conductivity. Thus, a physical metal deposition method is more preferable for the aforementioned metal processing.

There are no particular limitations on the aforementioned metal deposition method, and any arbitrary method can be selected. For example, a fabric to undergo metal processing may be placed in a deposition apparatus having a fixed degree of vacuum, and the fabric may be fed at a fixed speed and physically deposited with a deposition source.

In the case of EB deposition, for example, a metal is formed into fine particles by energy on the order of 1 EV after which the particles are physically adsorbed onto a fabric. In the case of ion plating, since deposited particles are accelerated and physically adsorbed at a higher energy level than rare gas or EV deposition, metal can be deposited deeper in the fabric. On the other hand, in the case of sputtering, metal can be accumulated at a higher energy level due to the effects of a magnetic field, thereby enabling metal to not only accumulate deep in the fabric, but also within fibers depending on the case. In this case, since a conductivity gradient can also be formed within fibers, the ability to absorb noise is further enhanced. In summary, although there is little damage to fabric and fibers in the case of mild deposition methods such as EB deposition, the physical adsorption force on fiber surfaces is weak. On the other hand, although there is considerable damage to fabric and fibers in the case of harsh deposition methods such as sputtering, physical adsorption force on fiber surfaces is high. The deposition method can be suitably selected corresponding to the application of the noise-absorbing fabric of the present invention.

In the present invention, there are no particular limitations on the metal deposited in the manner described above provided it has electrical conductivity, and examples thereof include aluminum, tantalum, niobium, titanium, molybdenum, iron, nickel, cobalt, chromium, copper, silver, gold, platinum, lead, tin, tungsten, SUS and other alloys, compounds such as oxides or nitrides thereof, and mixtures thereof.

In the case of metals such as aluminum or tantalum having a so-called valve action, namely metals that easily allow the obtaining of an oxide film only on the surface due to oxidation without allowing the oxide layer to easily propagate into the metal, a thin oxide film having slightly low conductivity is formed on the surface thereof. In the noise-absorbing fabric used in the present invention, if a metal having the aforementioned valve action is used for the metal to undergo metal processing, a microscopic conductivity gradient is formed between the surface and interior thereof that makes it possible to improve the ability to absorb noise, thereby making this preferable. In addition, as a result of employing a metal having valve action, a fixed surface resistance value is easily maintained without oxidation of the metal proceeding excessively during use. Although easily oxidized metals initially demonstrate favorable surface resistance values, depending on the environment in which they are used (such as high humidity or high temperature environments), oxidation proceeds more easily and surface resistance values increase, thereby resulting in the risk of it no longer being possible to demonstrate their inherent performance. In addition, in the case of metals such as gold, silver or copper, which have extremely high conductivity and allow uniform conductivity to be obtained even after metal processing, it is difficult to control metal processing and conductivity may become high in the same manner as a film or sheet.

On the other hand, in the present invention, the metal used for the aforementioned metal processing may or may not have ferromagnetism, paramagnetism or soft magnetism. The objective of the noise-absorbing fabric layer is not to macroscopically absorb noise by magnetism, but rather to absorb noise using conductivity.

In the present invention, although there are no particular limitations on the thickness of the metal provided the common logarithmic value of surface resistivity of the metal-processed surface is within the range of 0 to 6, in general, the thickness of the aforementioned metal is preferably within the range of 2 nm to 400 nm and more preferably within the range of 2 nm to 200 nm. If the thickness of the aforementioned metal is less than 2 nm, conductivity may easily fall outside the aforementioned range. Namely, during metal processing, portions where metal is not formed may remain and the common logarithmic value of surface resistivity may exceed 6. On the other hand, if the thickness of the aforementioned metal exceeds 400 nm, the aforementioned metal becomes excessively thick which may result in excessive current flow. Namely, if the aforementioned metal is excessively thick, a uniform layer is formed, spaces between fibers are filled in and there are hardly any gaps between the fibers, thereby increasing susceptibility to a decrease in the ability to absorb noise by switching effects.

Furthermore, in the present description, the aforementioned metal thickness can be measured using SEM micrographs and the like.

In the noise-absorbing fabric used in the present invention, in the case the aforementioned processed metal contains a plurality of metal clusters, the metal clusters preferably have an arithmetic average value of diameter of 2 nm to 200 nm, and more preferably have an arithmetic average value of diameter of 5 nm to 100 nm. As a result of the aforementioned processed metal having discontinuous metal clusters, a conductivity gradient is easily formed between each metal cluster. If the arithmetic average value of diameter of the metal clusters is 2 nm or more, noise can be absorbed more efficiently. In addition, if the arithmetic average value of diameter of the metal clusters is 200 nm or less, uniformity of the aforementioned processed metal is not excessively promoted, thereby allowing the formation of a favorable conductivity gradient. Since the aforementioned cluster structures are formed easily in a noise-absorbing fabric containing ultrafine fibers, the fabric is able to demonstrate a higher ability to absorb noise. The aforementioned diameter can be measured from images obtained with an SEM electron microscope.

Although there are no particular limitations on the magnetic layer used in the present invention provided it is a magnetic layer in which metal magnetic powder having a magnetic loss effect is dispersed in a binder, a powder is preferably used that has oxidized the metal surface. It is necessary to increase the filled amount of the magnetic body contained in the layer in order to improve the ability of the magnetic layer to absorb noise. However, when the filled amount of metal powder is increased, a plurality of the metal powders bind as a result of contact there between resulting in the formation of high apparent conductivity. In this case, the thickness of the conductor ends up becoming larger than the coating depth, eddy current ends up being generated, and noise absorption performance ends up worsening. In order to solve this, the surface of the metal powder is oxidized to increase surface resistance, thereby making it possible to inhibit the generation of eddy current by blocking electrical continuity between the metal even if the metal powder makes mutual contact.

The content of the magnetic body in the magnetic layer used in the present invention is preferably 55% by weight to 90% by weight, more preferably 70% by weight to 90% by weight and even more preferably 80% by weight to 90% by weight. If the content of the magnetic body is within the range of 55% by weight to 90% by weight, noise absorption performance of the magnetic layer can be improved, thereby making this preferable. If the content of the magnetic body in the magnetic layer is less than 55% by weight, the amount of magnetic powder is low and it may not be possible for the magnetic layer to obtain noise absorption performance. If the content of the magnetic body exceeds 90% by weight, mutual contact between the metal powder causes a plurality of metal powders to bond, resulting in the formation of an apparently large conductor, the thickness of the conductor ends up being larger than the coating depth, eddy current ends up being generated, and noise absorption performance ends up worsening. In addition, if the content of the magnetic body exceeds 90% by weight, this results in a corresponding decrease in the binder, thereby leading to a decrease in strength of the magnetic layer.

In addition, although the content of binder of the magnetic layer used in the present invention can be suitably set in order to adjust such parameters as mechanical strength, handling ease or insulating properties, it is preferably 10% by weight to 45% by weight, more preferably 10% by weight to 30% by weight, and even more preferably 10% by weight to 20% by weight. If the binder content is within the range of 10% by weight to 45% by weight, handling ease, pliancy, mechanical strength and insulating properties are suitable. If the binder content is less than 10% by weight, problems with mechanical strength may occur. Conversely, if the binder content exceeds 45% by weight, it is not possible to increase the filled amount of magnetic powder, thereby making it difficult to obtain high noise absorption performance. In the present invention, the binder may also contain agents required to form the magnetic layer, such as a magnetic body dispersant or flame retardant.

In the present invention, although there are no particular limitations on the order in which the metal-processed fabric and magnetic layer are laminated, by installing the magnetic layer on the side close to the noise source and installing the metal-processed fabric on the upper surface of the magnetic layer during actual use, it becomes difficult for problems to occur that are caused by impacts from the outside acting on the noise-absorbing sheet resulting in the magnetic powder falling off and causing a short-circuit when installed on the board of an electronic device.

In the present invention, there are no particular limitations on the shape of the metal magnetic powder used in the magnetic layer, and flat metal powder is preferable. As a result of orientating flat magnetic powder so as to form a layer, in comparison with the case of using a particulate magnetic powder, the magnetic powder is able to overlap, thereby making it possible to reduce the distance between powders and absorb noise more efficiently. In the present invention, the composition of the metal powder used in the magnetic layer preferably consists of a soft magnetic powder having large conductivity loss, namely a large imaginary component ($\mu''$) of magnetic permeability. For example, metal alloys composed mainly of Fe, Fe-Si-based alloys, Fe-Si-Al-based alloys, Fe-Ni-based alloys, Fe-Ni-Mo-based alloys, Fe-Ni-Mo-Cu-based alloys or Fe-Ni-Mo-Cu-based alloys are typically used frequently. Moreover, the magnetic powder may also contain elements such as Co, Ni, Si, Cr, Al, Zn, Mo, V or B in addition to Fe.

Magnetic permeability of the magnetic layer of the present invention is preferably 0.1 to 300, more preferably 0.1 to 250 and even more preferably 0.1 to 200.

In addition, in the present invention, although, for example, an ester-based resin, acrylic resin, urethane-based resin or rubber is used for the binder used in the magnetic layer, there are no particular limitations thereon. A binder that favorably disperses the metal magnetic powder used is preferable.

The present invention demonstrates higher noise absorbing effects by combining a noise-absorbing fabric having high electric field absorbing effects and a magnetic layer having high magnetic field absorbing effects. This is not the result of simply adding noise-absorbing effects when using the noise-absorbing fabric and magnetic layer separately, but rather is the result of being able to demonstrate effects that are greater than the sum thereof, thereby making the present invention considerably different from previous noise-absorbing sheets.

In other words, in the case of defining the electric field noise-absorbing effect of the fabric having metal adhered to constituent fibers thereof as Ae, the electric field noise-absorbing effect of the magnetic layer containing a magnetic material as Be, and the electric field noise-absorbing effect of the noise-absorbing sheet as Ce, then Ae + Be > Ce.

Moreover, in the case of defining the magnetic field noise-absorbing effect of the fabric having metal adhered to constituent fibers thereof as Am, the magnetic field noise-absorbing effect of the magnetic layer containing a magnetic material as Bm, and the magnetic field noise-absorbing effect of the noise-absorbing sheet as Cm, then Am + Bm > Cm. Measurement of electric field noise-absorbing effect and magnetic field noise-absorbing effect is performed as described in section (2) on Microstrip Line (MSL) Radiation Noise Measurement in the Examples to be subsequently described.

As was previously described, the noise-absorbing fabric attenuates noise by capturing electromagnetic waves that pass through the noise-absorbing fabric on a metal surface, converts them to an electrical current, and converts the electrical current to heat by electrical resistance. However, the noise-absorbing fabric does not have the ability to attract electromagnetic waves. Accordingly, it is only able to attenuate electromagnetic waves that pass through a surface where the noise-absorbing fabric is installed. On the other hand, the magnetic layer has the ability to attract electromagnetic waves to the sheet by the effect of the magnetic permeability ($\mu'$) of the magnetic powder thereof. Accordingly, by superimposing a magnetic body on the noise-absorbing fabric, electromagnetic waves can be captured that were unable to be captured with the noise-absorbing fabric alone, and the noise-absorbing fabric is able to convert the majority of noise into heat in comparison with when using the fabric alone. For this reason, the present invention is able to demonstrate effects that exceed those resulting from simply adding noise-absorbing effects when using each of the noise-absorbing fabric and magnetic layer alone.

As has been previously described, an essential condition of the noise-absorbing fabric used in the present invention is that it has noise absorption performance. Namely, it is difficult to obtain high noise-absorbing effects simply by superimposing a magnetic sheet on an electromagnetic wave shielding material such as conductive fabrics imparted with high electrical conductivity by performing metal processing on a nonwoven fabric or fabric, an electromagnetic wave shielding sheet obtained by performing metal deposition on a film surface, or an electromagnetic wave shielding material such as a metal plate. In addition, when an electromagnetic wave shielding material is compounded with a magnetic body, there is concern that the ability to absorb noise of the magnetic body alone cannot be adequately demonstrated due to the appearance of the reflection capacity of the electromagnetic shielding material over the entire surface.

In the present invention, there are no particular limitations on the method used to laminate the noise-absorbing fabric and the magnetic layer. For example, the magnetic layer can be coated onto the noise-absorbing fabric serving as a base material by screen printing, die coating, bar coating, roll coating or comma coating and the like. In addition, if the noise-absorbing fabric and magnetic layer are fabricated in advance by an ordinary coating method such as screen printing, die coating, bar coating, roll coating or comma coating, they can be laminated with a double-sided adhesive sheet or laminated with an adhesive by hot melting or dry lamination. The processing method may be selected in consideration of cost and processability.

In addition, in the present invention, although there are no particular limitations on the thickness of the magnetic layer, it is preferably 20 $\mu$m to 500 $\mu$m. The thickness of the magnetic layer is more preferably 20 $\mu$m to 300 $\mu$m and even more preferably 20 $\mu$m to 100 $\mu$m from the viewpoints of pliancy and handling ease. The thickness of the magnetic layer can be determined from SEM micrographs of magnetic layer cross-sections.

The following treatment can be performed on one side or both sides of the noise-absorbing sheet of the present invention in order to facilitate practical use in an electronic device and the like. For example, insulating treatment can be performed to prevent short-circuiting. More specifically, the sheet can be coated with a resin, laminated with a resin or laminated with an insulating film. In addition, treatment for imparting adhesiveness for laminating on an electronic device, or installation with screws or threaded holes for installing in the cabinet of an electronic device can be performed. Treatment for imparting adhesiveness for laminating on an electronic device is preferable since it facilitates immobilization of the sheet on the electronic device.

As indicated below, the noise-absorbing sheet of the present invention can be applied to an electronic device and the like to allow the electronic device to absorb noise. For example, the noise-absorbing sheet can be affixed to an LSI or other electronic component, affixed to a glass epoxy substrate, FPC or other circuit or the back side thereof, can be affixed to a site on a transmission line on a circuit where an electronic component is installed in the circuit, can be affixed to a connector or cable connected from a connector to another apparatus or component, affixed to the front or back of a cabinet or holder housing an electronic component or apparatus, or wound around a power line, transmission line or other cable.

In addition, an adhesive layer (such as a hot-melt adhesive or ordinary adhesive) for laminating to the aforementioned electronic devices and the like can be provided on the front or back as desired in consideration of ease of use, and in cases requiring insulating properties, an electrical insulating layer can be provided on the front or back of the aforementioned electronic devices and the like (a film can be laminated or a polylaminate layer can be provided, and an electrical insulating layer can be formed by combining with other insulating materials).

Examples

Although the following provides a more detailed explanation of the present invention by indicating examples thereof, the present invention is not limited to only these examples.

The measurement methods and evaluation methods used in the present invention are as indicated below.

(1) Microstrip Line (MSL) Conduction Noise Measurement

Conduction noise was measured using the microstrip line method in compliance with IEC standard 62333-2.

As shown in FIG. 7, conduction noise was measured according to the S-parameter method using a microstrip line fixture 10 having an impedance of 50 Ω (Microwave Factory Co., Ltd.) and a network analyzer 9 (Model N5230C, Agilent Technologies Inc.). The size of a sample of the noise-absorbing fabric was 5 cm x 5 cm, and the sample was measured by placing on the microstrip line fixture 7. Furthermore, reference symbol 12 in FIG. 7 indicates the microstrip line.

The S-parameter reflection coefficient (S11) and permeability coefficient (S21) were measured at each frequency, and the loss rate was calculated from the following Equation (1).

$$\text{Loss rate (Ploss/Pin)} = 1 - (S11^2 + S21^2)/1 \quad (1)$$

Note that $(S11)^2$ is reflection loss.

(2) Microstrip Line (MSL) Radiation Noise Measurement

As shown in FIG. 8, electromagnetic wave noise was generated in a microstrip line 12 using a microstrip line fixture 10 (Microwave Factory Co., Ltd.) having an impedance of 50 Ω and a network analyzer 9 (Model No. N5230C, Agilent Technologies Inc.), followed by measurement of magnetic field and electric field noise extending vertically upward from the microstrip line using an electric and magnetic field probe 13 (Model No. 100B and 100D-EMC probe, Beehive Electronics LLC) and a spectrum analyzer 14 (Model No. FSH8, Rohde & Schwarz DVS GmbH9). The size of a sample 11 of the noise-absorbing fabric was 5 cm x 5 cm, and the sample was measured by placing on the microstrip line fixture 10.

Calculation of noise-absorbing effect was as indicated in the following Equation (2).

$$\text{Noise-absorbing effect (dB)} = \text{noise level after installing noise-absorbing sheet (dBm)} - \text{noise level before installing noise-absorbing sheet (dBm)} \quad (2)$$

(3) Surface Resistivity

The surface resistivity was measured according to the four-terminal method using the Model MCP-T600 Loresta-GP Low Resistance Meter manufactured by Mitsubishi Chemical Corp. The average value of n = 3 measurements was used.

(4) Fabric Weight

The fabric weight was determined by measuring the weight of a sample measuring 20 cm long x 25 cm wide by sampling at three locations per 1 m of sample width in accordance with the method defined in JIS L-1906:2000, and converting the average value thereof to weight per unit area.

(5) Fabric Thickness

The thicknesses at 10 locations per 1 m of width were measured in accordance with the method defined in JIS L-1906:2000, and the average value thereof was taken to be fabric thickness. Measurements were performed at a load of 9.8 kPa.

(6) Diameter of Fabric Fibers

Fibers were selected arbitrarily from electron micrographs and the diameters thereof were read from the micrographs to determine an average fiber diameter (μm). The value is the arithmetic average for n = 50 fibers.

(7) Thickness of Coated Metal

The thickness of coated metal was determined from SEM micrographs using an SEM electron microscope (Model S-4800, Hitachi High-Technologies Corp.). The additive average value for n = 30 was used for each value.

(8) Fabric Average Opening Size

Measurements were performed using the Perm Porometer (Model CFP-1200AEX) manufactured by PMI. A fabric average opening size was measured using Silwick manufactured by PMI for the immersion liquid and immersing the sample in the immersion liquid followed by adequately degassing.
This measuring apparatus performs measurement by immersing a filter in a liquid having a preliminarily known surface tension, applying pressure to the filter in the state in which all pores of the filter are covered with a liquid membrane, and then measuring the size of the pores, as calculated from the pressure at which the liquid membrane ruptures, and the surface tension of the liquid. The following Equation (3) was used to calculate average opening size.

$$d = C \times r/P \quad (3)$$

(wherein, d (units: μm) represents the opening size of the filter, r (units: N/m) represents the surface tension of the liquid, P (units: Pa) represents the pressure at which the liquid membrane ruptured at that pore size, and C represents a constant).
When the flow rate (wet flow rate) is measured in the case of continuously changing the pressure P applied to the filter immersed in the liquid from low pressure to high pressure, the flow rate is 0 since the liquid membrane of the largest pores does not rupture at the initial pressure. As the pressure rises, the liquid membrane of the largest pores ruptures and flow is generated (bubble point). When the pressure rises further, the flow rate increases corresponding to each pressure, the liquid membrane of the smallest pores ruptures, and the flow rate coincides with the flow rate in the dry state (dry flow rate).
In this measuring apparatus, the value obtained by dividing the wet flow rate at a certain pressure by the dry flow rate at the same pressure is referred to as the cumulative filter flow rate (units: %). In addition, the pore size of the liquid membrane that is ruptured at a pressure equal to 50% of the cumulative filter flow rate is referred to as the average flow rate pore size, and this was taken to be the average opening size of the fabric used in the present invention.
In the present description, the maximum pore size was measured using the fabric as a filter, and was taken to be the pore size of the liquid membrane that is ruptured at the pressure at which the cumulative flow rate is within a range of $-2\sigma$ of 50%, or in other words, at the pressure at which the cumulative flow rate is 2.3%.

(9) Thickness of Magnetic Sheet

The thickness of the magnetic sheet was determined from SEM micrographs obtained using an SEM electron microscope (Model VE-8800, Keyence Corp.). The arithmetic average value for n = 30 was used for each value.

(10) Magnetic Permeability Measurement Method

Magnetic permeability was measured using a thin film magnetic permeability measurement system (Model PMF-3000, Ryowa Electronics Co., Ltd.). The sample was measured after affixing to a PET resin sheet with a double-sided tape (NW-5, Nichiban Co., Ltd.) in order to immobilize the sample. The average value of n = 3 measurements was used.

(11) Magnetic Body and Binder Contents of Magnetic Sheet

A magnetic sheet was cut out into the shape of a square measuring 8 cm on a side followed by measurement of the weight thereof. Subsequently, the binder was removed using a solvent suitable for dissolving the binder component of the magnetic sheet (such as nitric acid, hydrochloric acid, sodium hydroxide, hexane, toluene, normal hexanone, ethyl acetate, methyl alcohol or ethyl alcohol) followed by measuring the weight (g) of the magnetic body remaining after dissolved by the chemical agent. The weight of the binder was calculated by subtracting the weight of the magnetic body powder from the weight (g) of the magnetic sheet before dissolved by the chemical agent. The contents of the magnetic body and binder of the magnetic sheet were calculated from the weights (g) of the magnetic body and binder.

(12) Measurement of Electric Field Strength using Noise Absorption

Visualization Apparatus

Electric field strength was measured using a printed circuit board electromagnetic wave analysis system manufactured by Noise Laboratory Co., Ltd. (Model No. ESV-3000). A demo circuit board manufactured by Noise Laboratory Co., Ltd. was used for the printed board used in measurement. An electric field probe manufactured by Noise Laboratory Co., Ltd. was used for the measurement probe. The measuring frequency was set to 250 MHz to 700 MHz and the value of peak electric field strength within that measuring frequency range was mapped at each measurement point. The sample size was 13 cm x 18 cm, and the amount of attenuation of electric field strength was measured from the difference in electric field strength before and after affixing the sample to the demo board.

[Example 1]

Noise absorption performance was measured using a spun-bonded nonwoven fabric, made of polyester resin manufactured by Asahi Kasei Fibers Corp. (trade name: Precise, Cat. No. AS030) and produced according to the production method indicated below, for the fabric, performing metal processing thereon and laminating to a commercially available magnetic sheet.

General-purpose polyethylene terephthalate was extruded by spun bonding at a spinning temperature of 300°C with long fibers of filaments facing toward a movement collecting net surface, followed by spinning at a spinning speed of 3500 m/min, and sufficiently dispersing the fibers by charging at about 3 μC/g by corona discharge to form an unbound long fiber web, composed of filaments having an average fiber diameter of 11 μm and a uniformity fluctuation rate per 5 cm of 15% or less (to also be referred to as "Web Layer A"), at a fabric weight of about 7.5 $g/m^2$ on the collecting net surface.

Next, polyethylene terephthalate (melt viscosity ηsp/c: 0.50) was spun by melt blown method under conditions of a spinning temperature of 300°C, heating air temperature of 320°C and air discharge rate of 1000 $Nm^3/hr/m$, followed by directly spraying ultrafine fibers having an average fiber diameter of 1.7 μm towards the Web Layer A in the form of a random web having a fabric weight of about 5 $g/m^2$ (to also be referred to as "Web Layer B"). The distance from the melt blowing nozzles to the upper surface of Web Layer A was set at 100 mm, suction applied to the collecting surface directly below the melt blowing nozzles was set to 0.2 kPa, and the air flow rate was set to about 7 m/sec.

A long fiber web of polyethylene terephthalate of web A was dispersed on the side of Web Layer B of the opposite side from Web Layer A in the same manner as the initially prepared Web Layer A to prepare a three-layer laminated web consisting of Web Layer A, Web Layer B and Web Layer A in that order.

Next, the aforementioned three-layer laminated web was thermocompression bonded by passing through two flat rollers to obtain a three-layer laminated nonwoven fabric composed of nonwoven fabric layer A, nonwoven fabric layer B and nonwoven fabric layer A in that order.

A noise-absorbing fabric was formed by depositing a metal on the nonwoven fabric A derived from the initially formed Web Layer A of the resulting three-layer laminated spun-bonded nonwoven fabric (trade name: Precise, Cat. No. AS030).

Deposition was performed with a vacuum deposition apparatus using a standard board manufactured by Nilaco Corp. (Model No. SF-106, tungsten) for the heat source. Basic deposition conditions consisted of a degree of vacuum of $5 \times 10^{-5}$ torr, applied voltage of 5 V and deposition time of 180 seconds.

Furthermore, in the metal processing of Example 2 and subsequent examples, the aforementioned conditions were used for basic metal processing conditions, and in order to change the amount of metal processed, the degree of vacuum, amount of heat applied to the deposition source (or the amount of electricity applied to the heat source depending on the case) and deposition time were controlled and adjusted so as to impart a common logarithmic value of surface resistivity that lies within the range of the present invention. In general, in the case the metal to be processed has been decided, the amount of metal processed can be easily adjusted by changing the deposition time, for example. For example, deposition time can be decreased in the case of reducing the amount of metal to be processed, while deposition time can be increased in the case of increasing the amount of metal to be processed. In addition, with respect to the magnetic permeability of the noise-absorbing fabrics of Examples 1 to 10, the average value of μ' was roughly 1.0 within a range of 0.5 GHz to 6 GHz, and the average value of μ" was about 0.0 within a range of 0.5 GHz to 6 GHz.

A magnetic sheet manufactured by Daido Steel Co., Ltd. (thickness: 100 μm) was used for the magnetic sheet. Furthermore, a double-sided adhesive tape manufactured by 3M Co. (Cat. No. 9511) was used to laminate the noise-absorbing fabric and magnetic sheet.

The properties and evaluation results of the resulting noise-absorbing sheet are shown in the following Table 1. In addition, the results of measuring magnetic field noise and electric field noise are shown in FIG. 9 and FIG. 10, respectively, while the results of measuring according to the microstrip line method are shown in FIG. 19, and the results of mapping electric field distribution are shown in FIG. 24. Furthermore, FIG. 22 shows the board used to measure electric field distribution mapping with the noise absorption visualization apparatus, while FIG. 23 shows the results of electric field distribution mapping with the noise absorption visualization apparatus without affixing a sheet (blank state). On the basis of these results, both magnetic field noise and electric field noise can be understood to be effectively absorbed.

The following Table 3 indicates evaluation results in the case of defining the electric field noise-absorbing effect of a fabric having metal adhered to constituent fibers as Ae, the electric field noise-absorbing effect of a magnetic layer containing a magnetic material as Be, and the electric field noise-absorbing effect of the noise-absorbing sheet as Ce, and defining the magnetic field noise-absorbing effect of a fabric having metal adhered to constituent fibers as Am, the magnetic field noise-absorbing effect of a magnetic layer containing a magnetic material as Bm, and the magnetic field noise-absorbing effect of the noise-absorbing sheet as Cm. These results show the magnetic field noise and electric field noise are clearly effectively absorbed.

[Examples 2 to 24]

The compositions and properties of the noise-absorbing fabric and magnetic sheet were changed using the aforementioned Example 1 for the basic conditions. The changes are as indicated in the following Tables 1 and 2.

In Example 2, a magnetic sheet manufactured by Doosung Industrial Co., Ltd. was used for the commercially available magnetic sheet of Example 1.

In Example 3, a magnetic sheet manufactured by NEC Tokin Corp. (thickness: 100 μm) was used for the commercially available magnetic sheet of Example 1.

In Example 4, a magnetic sheet manufactured by the 3M Co. (thickness: 50 μm) was used for the commercially available magnetic sheet of Example 1.

Example 5 was performed in accordance with Example 1 with the exception of changing deposition time and thickness of the metal.

Example 6 was performed in accordance with Example 1 with the exception of changing the metal to Ag.

Example 7 was performed in accordance with Example 1 with the exception of changing the base material of the noise-absorbing fabric to AS022 (material: polyester, Asahi Kasei Fibers Corp.).

Example 8 was performed in accordance with Example 1 with the exception of changing the base material of the noise-absorbing fabric to E05050 (material: polyester, Asahi Kasei Fibers Corp.).

Example 9 was performed in accordance with Example 1 with the exception of changing the base material of the noise-absorbing fabric to E05050 (material: polyester, Asahi Kasei Fibers Corp.) and changing the adhered amount of metal.

Example 10 was performance in accordance with Example 1 with the exception of changing the base material of the noise-absorbing fabric to N05050 (material: Nylon 6, Asahi Kasei Fibers Corp.).

Example 11 was performed in accordance with the Example 1 with the exception of using an ester-based taffeta for the base material of the noise-absorbing fabric.

In Example 12, a magnetic sheet manufactured by Daido Steel Co., Ltd. (thickness: 50 μm) was used for the commercially available magnetic sheet of Example 1.

In Example 13, a magnetic sheet manufactured by Daido Steel Co., Ltd. (thickness: 300 μm) was used for the commercially available magnetic sheet of Example 1.

In Example 14, a magnetic sheet manufactured by Daido Steel Co., Ltd. (magnetic permeability at 1 MHz: 80) was used for the commercially available magnetic sheet of Example 1.

In Example 15, a magnetic sheet manufactured by Daido Steel Co., Ltd. (magnetic permeability at 1 MHz: 170) was used for the commercially available magnetic sheet of Example 1.

In Example 16, a magnetic sheet manufactured by the 3M Co. (thickness: 25 μm) was used for the commercially available magnetic sheet of Example 1.

In Examples 17 to 19, magnetic sheets having the compositions and properties described in the following Table 2 were used that were produced by an ordinary coating method using a slurry obtained by dispersing a commonly available magnetic body having Fe as the main component thereof in a binder.

Examples 20 and 21, magnetic sheets having the compositions and properties described in the following Table 2 were used that were produced by an ordinary coating method using a slurry obtained by dispersing a commonly available magnetic body having Fe as the main component thereof in a binder.

In Example 22, a magnetic sheet having the composition and properties described in the following Table 2 was used that was produced by an ordinary coating method using a slurry obtained by dispersing a commonly available magnetic body having Fe as the main component thereof in a binder.

In Example 23, a magnetic sheet having the composition and properties described in the following Table 2 was used that was produced by an ordinary coating method using a slurry obtained by dispersing a commonly available magnetic body having Fe as the main component thereof in a binder.

In Example 24, a magnetic sheet having the composition and properties described in the following Table 2 was used that was produced by an ordinary coating method using a slurry obtained by dispersing a commonly available magnetic body having Fe as the main component thereof in a binder.

The properties and evaluation results of the noise-absorbing sheets obtained in each of the examples are shown in the following Tables 1 and 2. In addition, the results of measuring magnetic field noise and electric field noise for Example 2 are respectively shown in FIGS. 11 and 12, and the results of measuring according to the microstrip line method are shown in FIG. 20. On the basis of these results, both the magnetic field noise and electric field noise can be understood to be effectively absorbed.

[Table 1]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Base material of noise-absorbing fabric | | AS030 | AS030 | AS030 | AS030 | AS030 | AS030 | AS022 | E05050 | E05050 | N05050 | Taffeta |
| Thickness of noise-absorbing fabric | µm | 30 | 30 | 30 | 30 | 30 | 30 | 22 | 170 | 170 | 170 | 100 |
| Fabric weight of noise-absorbing fabric | $g/m^2$ | 20 | 20 | 20 | 20 | 20 | 20 | 16 | 50 | 50 | 50 | 50 |
| Fiber diameter of ordinary fibers of noise-absorbing fabric | µm | 12 | 12 | 12 | 12 | 12 | 12 | 12 | 16 | 16 | 16 | 46 |
| Fiber diameter of ultrafine fibers of noise-absorbing fabric | µm | 1.7 | 1.7 | 1.7 | 1.7 | 1.7 | 1.7 | 1.7 | - | - | - | - |
| Average opening size of noise-absorbing fabric | µm | 9 | 9 | 9 | 9 | 9 | 9 | 12 | 20 | 20 | 18 | 110 |
| Type of coated metal of noise-absorbing fabric | | AL | AL | AL | AL | AL | Ag | AL | AL | AL | AL | AL |
| Thickness of coated metal of noise-absorbing fabric | nm | 52 | 52 | 52 | 52 | 30 | 54 | 56 | 50 | 5 | 45 | 32 |
| Absolute value of surface resistivity of noise-absorbing fabric | Ω/□ | 3 | 3 | 3 | 3 | 143 | 3 | 2 | 72.5 | 7250 | 70.4 | 22 |

(continued)

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Common logarithmic value of surface resistivity of noise-absorbing fabric | | 0.5 | 0.5 | 0.5 | 0.5 | 2.2 | 0.5 | 0.3 | 1.9 | 3.9 | 1.8 | 1.3 |
| | | | | | | | | | | | | |
| Magnetic sheet (manufacturer) | | Daido Steel | Doosung | NEC Tokin | 3M | Daido Steel | Daido Steel | Daido Steel | Daido Steel | Daido Steel | Daido Steel | Daido Steel |
| Magnetic sheet thickness | | 100 | 100 | 100 | 50 | 100 | 100 | 100 | 100 | 100 | 100 | 100 |
| Magnetic sheet magnetic permeability (1 MHz) | | 130 | 20 | 60 | 110 | 130 | 130 | 130 | 130 | 130 | 130 | 130 |
| Magnetic powder content of magnetic sheet | wt% | 87 | 86 | 87 | 85 | 87 | 87 | 87 | 87 | 87 | 87 | 87 |
| Binder content of magnetic sheet | wt% | 13 | 14 | 13 | 15 | 13 | 13 | 13 | 13 | 13 | 13 | 13 |
| | | | | | | | | | | | | |
| MSL conduction noise measurement results of complex sheet (noise-absorbing sheet + magnetic sheet) | | | | | | | | | | | | |
| Loss rate: 1 GHz | | 0.64 | 0.60 | 0.62 | 0.72 | 0.65 | 0.56 | 0.64 | 0.40 | 0.37 | 0.41 | 0.37 |
| $S11^2$ value: 1GHz | | 0.07 | 0.04 | 0.04 | 0.01 | 0.04 | 0.18 | 0.07 | 0.03 | 0.03 | 0.02 | 0.03 |
| Loss rate: 3 GHz | | 0.95 | 0.95 | 0.96 | 0.91 | 0.97 | 0.95 | 0.95 | 0.88 | 0.85 | 0.89 | 0.84 |

(continued)

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| $S11^2$ value: 3 GHz | | 0.04 | 0.02 | 0.04 | 0.08 | 0.02 | 0.02 | 0.04 | 0.02 | 0.02 | 0.01 | 0.02 |
| Loss rate: 10 GHz | | 0.97 | 0.97 | 0.97 | 0.97 | 0.97 | 0.97 | 0.97 | 0.95 | 0.94 | 0.95 | 0.95 |
| $S11^2$ value: 10 GHz | | 0.01 | 0.01 | 0.01 | 0.01 | 0.00 | 0.01 | 0.01 | 0.01 | 0.01 | 0.01 | 0.01 |
| | | | | | | | | | | | | |
| MSL radiation noise measurement results (2.45 GHz) | | | | | | | | | | | | |
| Magnetic field | dB | -8.4 | -7.9 | -8.0 | -8.5 | -8.7 | -9.0 | -8.5 | -4.5 | -2.3 | -4.3 | -2.2 |
| Electric field | dB | -17.5 | -14.0 | -14.2 | -17.3 | -17.4 | -16.0 | -17.2 | -9.3 | -7.8 | -9.2 | -8.9 |

[Table 2]

| | | Example 12 | Example 13 | Example 14 | Example 15 | Example 16 | Example 17 | Example 18 | Example 19 | Example 20 | Example 21 | Example 22 | Example 23 | Example 24 |
|---|---|---|---|---|---|---|---|---|---|---|---|---|---|---|
| Base material of noise-absorbing fabric | | AS030 | AS030 | AS030 | AS030 | AS030 | AS030 | AS030 | AS030 | AS030 | AS030 | AS030 | AS030 | AS030 |
| Thickness of noise-absorbing fabric | µm | 30 | 30 | 30 | 30 | 30 | 30 | 30 | 30 | 30 | 30 | 30 | 30 | 30 |
| Fabric weight of noise-absorbing fabric | $g/m^2$ | 20 | 20 | 20 | 20 | 20 | 20 | 20 | 20 | 20 | 20 | 20 | 20 | 20 |
| Fiber diameter of ordinary fibers of noise-absorbing fabric | µm | 12 | 12 | 12 | 12 | 12 | 12 | 12 | 12 | 12 | 12 | 12 | 12 | 12 |
| Fiber diameter of ultrafine fibers of noise-absorbing fabric | µm | 1.7 | 1.7 | 1.7 | 1.7 | 1.7 | 1.7 | 1.7 | 1.7 | 1.7 | 1.7 | 1.7 | 1.7 | 1.7 |
| Average opening size of noise-absorbing fabric | µm | 9 | 9 | 9 | 9 | 9 | 9 | 9 | 9 | 9 | 9 | 9 | 9 | 9 |
| Type of coated metal of noise-absorbing fabric | | AL | AL | AL | AL | AL | AL | AL | AL | AL | AL | AL | AL | AL |
| Thickness of coated metal of noise-absorbing fabric | nm | 52 | 52 | 52 | 52 | 52 | 52 | 52 | 52 | 52 | 52 | 52 | 52 | 52 |
| Absolute value of surface resistivity of noise-absorbing fabric | Ω/□ | 3 | 3 | 3 | 3 | 3 | 3 | 3 | 3 | 3 | 3 | 3 | 3 | 3 |

(continued)

| | | Example 12 | Example 13 | Example 14 | Example 15 | Example 16 | Example 17 | Example 18 | Example 19 | Example 20 | Example 21 | Example 22 | Example 23 | Example 24 |
|---|---|---|---|---|---|---|---|---|---|---|---|---|---|---|
| Common logarithmic value of surface resistivity of noise-absorbing fabric | | 0.5 | 0.5 | 0.5 | 0.5 | 0.5 | 0.5 | 0.5 | 0.5 | 0.5 | 0.5 | 0.5 | 0.5 | 0.5 |
| | | | | | | | | | | | | | | |
| Magnetic sheet (manufacturer) | | Daido Steel | Daido Steel | Daido Steel | Daido Steel | 3M | | | | | | | - | - |
| Magnetic sheet thickness | | 50 | 300 | 100 | 100 | 25 | 100 | 100 | 100 | 50 | 50 | 450 | 25 | 25 |
| Magnetic sheet magnetic permeability (1 MHz) | | 130 | 130 | 80 | 170 | 110 | 130 | 130 | 130 | 10 | 10 | 10 | 10 | 170 |
| Magnetic powder content of magnetic sheet | wt% | 87 | 87 | 87 | 87 | 85 | 40 | 56 | 77 | 80 | 72 | 80 | 80 | 80 |
| Binder content of magnetic sheet | wt% | 13 | 13 | 13 | 13 | 15 | 60 | 44 | 23 | 20 | 28 | 20 | 20 | 20 |
| | | | | | | | | | | | | | | |
| MSL conduction noise measurement results of complex sheet (noise-absorbing sheet + magnetic sheet) | | | | | | | | | | | | | | |
| Loss rate: 1 GHz | | 0.62 | 0.64 | 0.62 | 0.63 | 0.62 | 0.59 | 0. 64 | 0.62 | 0.75 | 0.72 | 0.67 | 0.61 | 0.61 |
| $S11^2$ value: 1GHz | | 0.07 | 0.07 | 0.07 | 0.07 | 0.01 | 0.02 | 0.07 | 0.07 | 0.07 | 0.06 | 0.06 | 0.03 | 0.07 |

(continued)

| | | Example 12 | Example 13 | Example 14 | Example 15 | Example 16 | Example 17 | Example 18 | Example 19 | Example 20 | Example 21 | Example 22 | Example 23 | Example 24 |
|---|---|---|---|---|---|---|---|---|---|---|---|---|---|---|
| Loss rate: 3 GHz | | 0.94 | 0.95 | 0.95 | 0.96 | 0.9 | 0.93 | 0.95 | 0.95 | 0.96 | 0.96 | 0.95 | 0.94 | 0.93 |
| $S11^2$ value: 3 GHz | | 0.02 | 0.04 | 0.03 | 0.04 | 0.06 | 0.04 | 0.04 | 0.03 | 0.03 | 0.02 | 0.04 | 0.04 | 0.03 |
| Loss rate: 10 GHz | | 0.97 | 0.98 | 0.97 | 0.98 | 0.97 | 0.96 | 0.97 | 0.97 | 0.97 | 0.96 | 0.98 | 0.97 | 0.97 |
| $S11^2$ value: 10 GHz | | 0.01 | 0.01 | 0.01 | 0.02 | 0.01 | 0.02 | 0.01 | 0.02 | 0.01 | 0.01 | 0.01 | 0.01 | 0.01 |
| | | | | | | | | | | | | | | |
| MSL radiation noise measurement results (2.45 GHz) | | | | | | | | | | | | | | |
| Magnetic field | | -8.0 | -9.1 | -7.9 | -8.8 | -8.1 | -4.6 | -5.0 | -7.8 | -9.5 | -9.2 | -8.5 | -7.1 | -7.5 |
| Electric field | | -13.5 | -18.2 | -12.9 | -17.7 | -12.3 | -6.4 | -7.3 | -10.4 | -10.0 | -9.3 | -16.6 | -8.3 | - |

[Table 3]

| | | Comp. Ex. 1 | Comp. Ex. 2 | Example 1 | Comp. Ex. 1 | Comp. Ex. 3 | Example 2 |
|---|---|---|---|---|---|---|---|
| Electric field noise-absorbing effect of layer of fabric having metal adhered to constituent fibers Ae | dB | -5.3 | - | - | -5.3 | - | - |
| Electric field noise-absorbing effect of magnetic layer containing magnetic material Be | dB | - | -4.8 | - | - | -1.4 | - |
| Ae + Be | dB | -10.1 | | - | -6.7 | | - |
| Electric field noise-absorbing effect of noise-absorbing sheet Ce | dB | - | - | -17.5 | - | - | -14.0 |
| Magnetic field noise-absorbing effect of layer of fabric having metal adhered to constituent fibers Am | dB | -4.2 | - | - | -4.2 | - | - |
| Magnetic field noise-absorbing effect of magnetic layer containing magnetic material Bm | dB | - | -0.2 | - | - | -1.1 | - |
| Am + Bm | dB | -4.4 | | - | -5.3 | | - |
| Magnetic field noise-absorbing effect of noise-absorbing sheet Cm | dB | - | - | -8.4 | - | - | -7.9 |

[Comparative Examples 1 to 10]

Changes made to each of the comparative examples using the basic conditions of the aforementioned Example 1 are indicated below.

In Comparative Example 1, measurements were performed using only the noise-absorbing fabric of Example 1.

In Comparative Example 2, measurements were performed using only a magnetic sheet manufactured by Daido Steel Co., Ltd. (thickness: 100 μm).

In Comparative Example 3, measurements were performed using only a magnetic sheet manufactured by Doosung Industrial Co., Ltd. (thickness: 100 μm).

In Comparative Example 4, measurements were performed using only magnetic sheet manufactured by NEC Tokin Corp. (thickness: 100 μm).

In Comparative Example 5, measurements were performed using only a magnetic sheet manufactured by the 3M Co. (thickness: 50 μm).

In Comparative Example 6, measurements were performed using only the noise-absorbing fabric of Example 8.

In Comparative Example 7, measurements were performed using only the noise-absorbing fabric of Example 7.

Comparative Example 8 was performed in accordance with Example 8 with the exception of changing the deposition time and changing the thickness of the metal.

Comparative Example 9 was performed in accordance with Example 1 with the exception of using a shielding fabric for electromagnetic wave shielding (Cu-Ni-plated fabric) instead of the noise-absorbing fabric.

Comparative Example 10 was performed in accordance with Example 1 with the exception of changing the metal to Ag and changing the amount of metal deposited by changing the deposition time.

Comparative Example 11 was performed in accordance with Example 1 with the exception of using a metal-processed film instead of the noise-absorbing fabric.

In Comparative Example 12, measurements were performed using only a magnetic sheet manufactured by Daido Steel Co., Ltd. (thickness: 50 μm).

In Comparative Example 13, measurements were performed using only a magnetic sheet manufactured by Daido Steel Co., Ltd. (thickness: 300 μm).

In Comparative Example 14, measurements were performed using only a magnetic sheet manufactured by Daido Steel Co., Ltd. (magnetic permeability at 1 MHz: 80).

In Comparative Example 15, measurements were performed using only a magnetic sheet manufactured by Daido Steel Co., Ltd. (magnetic permeability at 1 MHz: 170).

In Comparative Example 16, measurements were performed using only a magnetic sheet manufactured by the 3M Co. (thickness: 25 μm).

In Comparative Examples 17 to 19, measurements were performed using only magnetic sheets having the compositions and properties described in the following Table 5 that were produced by an ordinary coating method using a slurry obtained by dispersing a commonly available magnetic body having Fe as the main component thereof in a binder.

In Comparative Examples 20 and 21, magnetic sheets having the compositions and properties described in the following Table 5 were used that were produced by an ordinary coating method using a slurry obtained by dispersing a commonly available magnetic body having Fe as the main component thereof in a binder.

In Comparative Example 22, measurements were performed using only a magnetic sheet having the composition and properties described in the following Table 5 that was produced by an ordinary coating method using a slurry obtained by dispersing a commonly available magnetic body having Fe as the main component thereof in a binder.

In Comparative Example 23, measurements were performed using only a magnetic sheet having the composition and properties described in the following Table 5 that was produced by an ordinary coating method using a slurry obtained by dispersing a commonly available magnetic body having Fe as the main component thereof in a binder.

In Comparative Example 24, measurements were performed using only a magnetic sheet having the composition and properties described in the following Table 5 that was produced by an ordinary coating method using a slurry obtained by dispersing a commonly available magnetic body having Fe as the main component thereof in a binder.

In Comparative Example 25, measurements were performed using only the noise-absorbing fabric of Example 6.

In Comparative Example 26, measurements were performed using only the noise-absorbing fabric of Example 9.

In Comparative Example 27, measurements were performed using only the noise-absorbing fabric of Example 10.

In Comparative Example 28, measurements were performed using only the noise-absorbing fabric of Example 11.

The properties and evaluation results of the noise-absorbing sheets used in each of the comparative examples are shown in the following Tables 4 to 6. In addition, the results of measuring the electric field noise and magnetic field noise of Comparative Example 1 are respectively shown in FIGS. 13 and 14, the results of measuring the electric field noise and magnetic field noise of Comparative Example 2 are respectively shown in FIGS. 15 and 16, and the results of measuring the electric field noise and magnetic field noise of Comparative Example 3 are respectively shown in FIGS. 17 and 18.

Moreover, the results of measuring according to the microstrip line method in Comparative Example 9 are shown in FIG. 21, while the results of electric field distribution mapping are shown in FIG. 25. Based on the results of FIG. 21, when the common logarithmic value of surface resistivity of the noise-absorbing fabric is less than 0, the reflection (S11) component becomes large and the ability to absorb noise (P-loss/P-in) is inhibited. In addition, according to FIG. 25, if the common logarithmic value of surface resistivity of the noise-absorbing fabric is less than 0, the ability to absorb noise decreases as previously described, and since noise is not consumed within the fabric, noise can be understood to radiate secondarily from the edge of the sheet (red color distributed at the edge of the sheet). This indicates that unexpected noise is being generated within the electronic device, and on the basis of this as well, a base material in which the common logarithmic value of surface resistivity is less than 0 is not suitable for the present invention.

[Table 4]

| | | Comp. Ex.1 | Comp. Ex.2 | Comp. Ex.3 | Comp. Ex4 | Comp. Ex.5 | Comp. Ex.6 | Comp. Ex.7 | Comp. Ex.8 | Comp. Ex.9 | Comp. Ex.10 | Comp. Ex.11 |
|---|---|---|---|---|---|---|---|---|---|---|---|---|
| Base material of noise-absorbing fabric | | AS030 | - | - | - | - | E05050 | AS022 | E05050 | Shielding fabric | AS030 | PET film |
| Thickness of noise-absorbing fabric | μm | 30 | - | - | - | - | 170 | 22 | 170 | 170 | 30 | 16 |
| Fabric weight of noise-absorbing fabric | $g/m^2$ | 20 | - | - | - | - | 50 | 16 | 50 | 50 | 20 | - |
| Fiber diameter of ordinary fibers of noise-absorbing fabric | μm | 12 | - | - | - | - | 16 | 12 | 16 | 16 | 12 | - |
| Fiber diameter of ultrafine fibers of noise-absorbing fabric | μm | 1.7 | - | - | - | - | - | 1.7 | - | - | 1.7 | - |
| Average opening size of noise-absorbing fabric | μm | 9 | - | - | - | - | 20 | 12 | 20 | - | 9 | - |
| Type of coated metal of noise-absorbing fabric | | AL | - | - | - | - | AL | AL | AL | Cu-Ni | Ag | Ag |
| Thickness of coated metal of noise-absorbing fabric | nm | 52 | - | - | - | - | 50 | 56 | - | - | 200 | 10 |
| Absolute value of surface resistivity of noise-absorbing fabric | Ω/□ | 32 | - | - | - | - | 72.5 | 2 | 1.8E+06 | 0.03 | 0.08 | 0.8 |
| Common logarithmic value of surface resistivity of noise-absorbing fabric | | 1.5 | - | - | - | - | 1.9 | 0.3 | 6.3 | -1.4 | -1.1 | -0.1 |
| | | | | | | | | | | | | |
| Magnetic sheet | | - | Daido Steel | Doosun g | NEC Tokin | 3M | - | - | Daido Steel | Daido Steel | Daido Steel | Daido Steel |
| Magnetic sheet thickness | | - | 100 | 100 | 100 | 50 | - | - | 100 | 100 | 100 | 100 |
| Magnetic sheet magnetic permeability (1 MHz) | | - | 130 | 20 | 60 | 110 | - | - | 130 | 130 | 130 | 130 |

(continued)

| | | Comp. Ex.1 | Comp. Ex.2 | Comp. Ex.3 | Comp. Ex4 | Comp. Ex.5 | Comp. Ex.6 | Comp. Ex.7 | Comp. Ex.8 | Comp. Ex.9 | Comp. Ex.10 | Comp. Ex.11 |
|---|---|---|---|---|---|---|---|---|---|---|---|---|
| Magnetic powder content of magnetic sheet | wt% | - | 87 | 86 | 87 | 85 | - | - | 87 | 87 | 87 | 87 |
| Binder content of magnetic sheet | wt% | - | 13 | 14 | 13 | 15 | - | - | 13 | 13 | 13 | 13 |
| | | | | | | | | | | | | |
| MSL conduction noise measurement results | | | | | | | | | | | | |
| Loss rate: 1 GHz | | 0.60 | 0.37 | 0.16 | 0.21 | 0.25 | 0.18 | 0.59 | 0.37 | 0.21 | 0.18 | 0.15 |
| $S11^2$ value: 1GHz | | 0.02 | 0.07 | 0.00 | 0.06 | 0.02 | 0.01 | 0.02 | 0.07 | 0.31 | 0.72 | 0.68 |
| Loss rate: 3 GHz | | 0.90 | 0.84 | 0.43 | 0.48 | 0.65 | 0.55 | 0.92 | 0.84 | 0.30 | 0.23 | 0.30 |
| $S11^2$ value: 3 GHz | | 0.04 | 0.02 | 0.00 | 0.03 | 0.01 | 0.04 | 0.03 | 0.02 | 0.64 | 0.68 | 0.61 |
| Loss rate: 10 GHz | | 0.97 | 0.94 | 0.73 | 0.88 | 0.91 | 0.91 | 0.96 | 0.94 | 0.70 | 0.09 | 0.12 |
| $S11^2$ value: 10 GHz | | 0.01 | 0.02 | 0.01 | 0.16 | 0.04 | 0.03 | 0.02 | 0.02 | 0.21 | 0.90 | 0.85 |
| | | | | | | | | | | | | |
| MSL radiation noise measurement results (2.45 GHz) | | | | | | | | | | | | |
| Magnetic field | dB | -4.2 | -0.2 | -1.1 | -0.1 | -0.2 | -1.0 | -4.1 | -0.2 | - | - | - |
| Electric field | dB | -5.3 | -4.8 | -1.4 | -3.1 | -4.0 | -1.4 | -5.4 | -4.8 | - | - | - |
| | | | | | | | | | | | | |
| Adverse effects | | - | - | - | - | - | - | - | - | Large reflection | Large reflection | Large reflection |

[Table 5]

| | | Comp. Ex.12 | Comp. Ex.13 | Comp. Ex.14 | Comp. Ex.15 | Comp. Ex.16 | Comp. Ex.17 | Comp. Ex. 18 | Comp. Ex.19 | Comp. Ex.20 | Comp. Ex.21 | Comp. Ex.22 | Comp. Ex.23 | Comp. Ex.24 |
|---|---|---|---|---|---|---|---|---|---|---|---|---|---|---|
| Magnetic sheet | | Daido Steel | Daido Steel | Daido Steel | Daido Steel | 3M | - | - | - | - | - | - | - | - |
| Magnetic sheet thickness | | 50 | 300 | 100 | 100 | 25 | 100 | 100 | 100 | 50 | 50 | 450 | 25 | 25 |
| Magnetic sheet magnetic permeability (1 MHz) | | 130 | 130 | 80 | 170 | 110 | 130 | 130 | 130 | 10 | 10 | 10 | 10 | 170 |
| Magnetic powder content of magnetic sheet | wt% | 87 | 87 | 87 | 87 | 85 | 40 | 56 | 77 | 80 | 72 | 80 | 80 | 80 |
| Binder content of magnetic sheet | wt% | 13 | 13 | 13 | 13 | 15 | 60 | 44 | 23 | 20 | 28 | 20 | 20 | 20 |
| | | | | | | | | | | | | | | |
| MSL conduction noise measurement results | | | | | | | | | | | | | | |
| Loss rate: 1 GHz | | 0.25 | 0.45 | 0.28 | 0.39 | 0.21 | 0.10 | 0.22 | 0.37 | 0.05 | 0.04 | 0.08 | 0.06 | 0.22 |
| $S11^2$ value: 1GHz | | 0.03 | 0.08 | 0.06 | 0.07 | 0.04 | 0.02 | 0.06 | 0.07 | 0.01 | 0.01 | 0.01 | 0.01 | 0.06 |
| Loss rate: 3 GHz | | 0.50 | 0.88 | 0.71 | 0.85 | 0.72 | 0.53 | 0.76 | 0.84 | 0.12 | 0.10 | 0.20 | 0.17 | 0.81 |
| $S11^2$ value: 3 GHz | | 0.02 | 0.05 | 0.03 | 0.03 | 0.01 | 0.02 | 0.02 | 0.02 | 0.01 | 0.01 | 0.02 | 0.02 | 0.03 |
| Loss rate: 10 GHz | | 0.74 | 0.96 | 0.80 | 0.96 | 0.91 | 0.73 | 0.92 | 0.99 | 0.18 | 0.17 | 0.24 | 0.22 | 0.90 |
| $S11^2$ value: 10 GHz | | 0.02 | 0.05 | 0.02 | 0.02 | 0.04 | 0.02 | 0.02 | 0.02 | 0.01 | 0.01 | 0.01 | 0.01 | 0.02 |
| | | | | | | | | | | | | | | |
| MSL radiation noise measurement results (2.45 GHz) | | | | | | | | | | | | | | |
| Magnetic field | dB | -0.2 | -0.4 | -0.2 | -0.3 | -0.2 | -0.1 | -0.1 | -0.2 | -0.1 | -0.1 | -0.2 | -0.2 | -0.3 |
| Electric field | dB | -3.1 | -6.3 | -4.2 | -5.2 | -2.5 | -1.0 | -2.9 | -3.4 | -0.1 | -0.1 | -0.3 | -0.2 | -1.5 |
| | | | | | | | | | | | | | | |

(continued)

| | | | | | | | | | | | | | | |
|---|---|---|---|---|---|---|---|---|---|---|---|---|---|---|
| MSL radiation noise measurement results (2.45 GHz) | | | | | | | | | | | | | | |
| Adverse effects | | - | - | - | - | - | - | - | - | - | - | - | - | - |

[Table 6]

| | | Comp. Ex.25 | Comp. Ex.26 | Comp. Ex.27 | Comp. Ex.28 |
|---|---|---|---|---|---|
| Base material of noise-absorbing fabric | | AS030 | EO5050 | N05050 | Taffeta |
| Thickness of noise-absorbing fabric | μm | 30 | 170 | 170 | 100 |
| Fabric weight of noise-absorbing fabric | g/m2 | 20 | 50 | 50 | 50 |
| Fiber diameter of ordinary fibers of noise-absorbing fabric | μm | 12 | 16 | 16 | 46 |
| Fiber diameter of ultrafine fibers of noise-absorbing fabric | μm | 1.7 | - | - | - |
| Average opening size of noise-absorbing fabric | μm | 9 | 20 | 18 | 110 |
| Type of coated metal of noise-absorbing fabric | | Ag | AL | AL | AL |
| Thickness of coated metal of noise-absorbing fabric | nm | 54 | 5 | 45 | 32 |
| Absolute value of surface resistivity of noise-absorbing fabric | Ω/□ | 3 | 7250 | 70 | 22 |
| Common logarithmic value of surface resistivity of noise-absorbing fabric | | 0.5 | 3.9 | 1.8 | 1.3 |
| | | | | | |
| Magnetic sheet | | - | - | - | - |
| Magnetic sheet thickness | | - | - | - | - |
| Magnetic sheet magnetic permeability (1 MHz) | | - | - | - | - |
| Magnetic powder content of magnetic sheet | wt% | - | - | - | - |
| Binder content of magnetic sheet | wt% | - | - | - | - |
| | | | | | |
| MSL conduction noise measurement results | | | | | |
| Loss rate: 1 GHz | | 0.48 | 0.11 | 0.18 | 0.05 |
| S11$^2$ value: 1GHz | | 0.19 | 0.01 | 0.01 | 0.01 |
| Loss rate: 3 GHz | | 0. 68 | 0.38 | 0.54 | 0.25 |
| S11$^2$ value: 3 GHz | | 0.19 | 0.01 | 0.04 | 0.01 |
| Loss rate: 10 GHz | | 0.79 | 0.82 | 0.90 | 0.55 |
| S11$^2$ value: 10 GHz | | 0.02 | 0.04 | 0.03 | 0.01 |
| | | | | | |
| MSL radiation noise measurement results (2.45 GHz) | | | | | |
| Magnetic field | dB | -4.0 | -1.8 | -2.5 | -1.3 |
| Electric field | dB | -5.1 | -2.3 | -2.7 | 2.8 |
| | | | | | |
| Adverse effects | | - | - | - | - |

## INDUSTRIAL APPLICABILITY

The noise-absorbing sheet of the present invention is resistant to reflection of electromagnetic waves, demonstrates superior ability to absorb noise, demonstrates effects against noise over a wide bandwidth, and has highly effective noise-absorbing effects against both electric field and magnetic field noise components, thereby having an extremely high level of industrial applicability.

BRIEF DESCRIPTION OF THE REFERENCE SYMBOLS

1 Noise-absorbing sheet
2 Magnetic layer
3 Noise-absorbing fabric
4 Magnetic body particles
5 Binder
6 Metal
7 Fibers
8 Metal clusters
9 Network analyzer
10 Microstrip line fixture
11 Sample
12 Microstrip line
13 Magnetic field and electric field probe
14 Spectrum analyzer

## Claims

1. A noise-absorbing sheets comprising the lamination of at least two layers, wherein a magnetic layer containing a magnetic material and a noise-absorbing fabric layer having a metal adhered to constituent fibers are laminated, and the common logarithmic value of the surface resistivity on at least one side of the noise-absorbing fabric is within the range of 0 to 6.

2. The noise-absorbing sheet according to claim 1, wherein the fabric is a nonwoven fabric composed of synthetic long fibers.

3. The noise-absorbing sheet according to claim 1 or 2, wherein the fabric contains fibers having a fiber diameter of greater than 7.0 μm to 50 μm.

4. The noise-absorbing sheet according to any of claims 1 to 3, wherein the fabric contains fibers having a fiber diameter of 7.0 μm or less.

5. The noise-absorbing sheet according to claim 4, wherein the fabric is a fabric consisting of a mixture of fibers having a diameter of greater than 7.0 μm to 50 μm and fibers having a fiber diameter of 0.01 μm to 7.0 μm.

6. The noise-absorbing sheet according to claim 5, wherein the fabric is a laminated fabric having at least two layers consisting of a first layer and a second layer, the first layer is a layer of a nonwoven fabric composed of fibers having a fiber diameter of greater than 7 μm to 50 μm, and the second layer is a layer of a nonwoven fabric composed of fibers having a fiber diameter of 0.01 μm to 7.0 μm.

7. The noise-absorbing sheet according to claim 6, wherein the fabric is a laminated fabric having at least three layers consisting of a first layer, a second layer and a third layer in that order, the first layer and the third layer are layers of a nonwoven fabric composed of fibers having a fiber diameter of greater than 7 μm to 50 μm, and the second layer is a layer of a nonwoven fabric composed of fibers having a fiber diameter of 0.01 μm to 7.0 μm.

8. The noise-absorbing sheet according to any of claims 1 to 7, wherein the thickness of the fabric is 10 μm to 400 μm and the fabric weight is 7 $g/m^2$ to 300 $g/m^2$.

9. The noise-absorbing sheet according to any of claims 1 to 8, wherein the thickness of the magnetic layer is 20 μm to 500 μm.

**10.** The noise-absorbing sheet according to any of claims 1 to 9, wherein the magnetic layer contains 55% by weight to 90% by weight of a metal magnetic powder and 10% by weight to 45% by weight of a binder.

**11.** The noise-absorbing sheet according to any of claims 1 to 10, wherein reflection loss $(S11)^2$ at 1 GHz is 0.2 or less.

**12.** The noise-absorbing sheet according to any of claims 1 to 11, wherein, in the case of defining the electric field noise-absorbing effect of the layer of the noise-absorbing fabric having metal adhered to constituent fibers as Ae, the electric field noise-absorbing effect of the magnetic layer containing a magnetic material as Be, and the electric field noise-absorbing effect of the noise-absorbing sheet as Ce, then $Ae + Be > Ce$.

**13.** The noise-absorbing sheet according to any of claims 1 to 12, wherein, in the case of defining the magnetic field noise-absorbing effect of the noise-absorbing fabric having metal adhered to constituent fibers as Am, the magnetic field noise-absorbing effect of the magnetic layer containing a magnetic material as Bm, and the magnetic field noise-absorbing effect of the noise-absorbing sheet as Cm, then $Am + Bm > Cm$.

FIG. 1

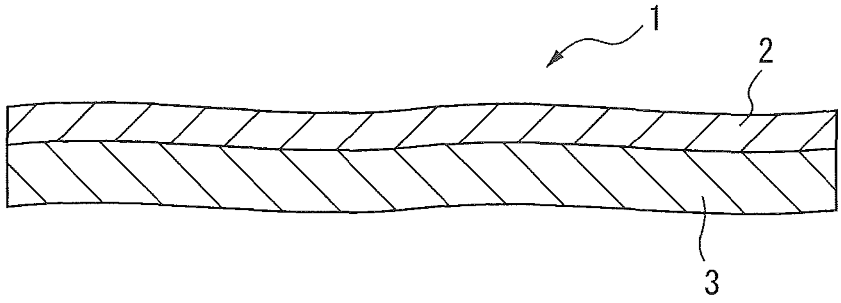


FIG. 2

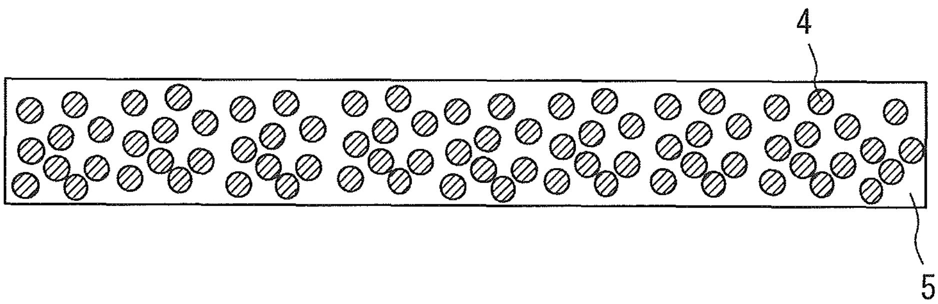


FIG. 3

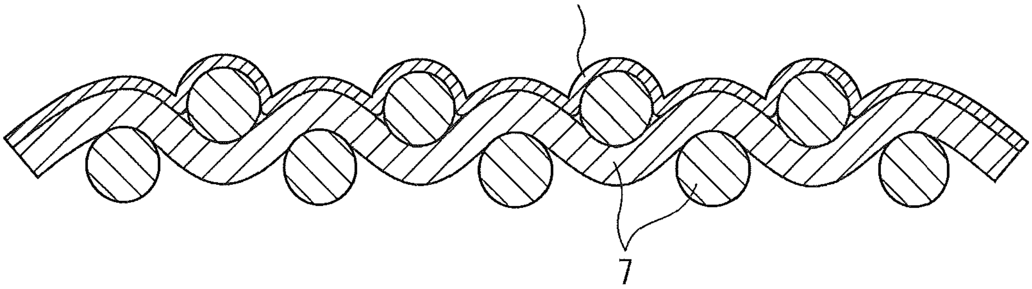

FIG. 4

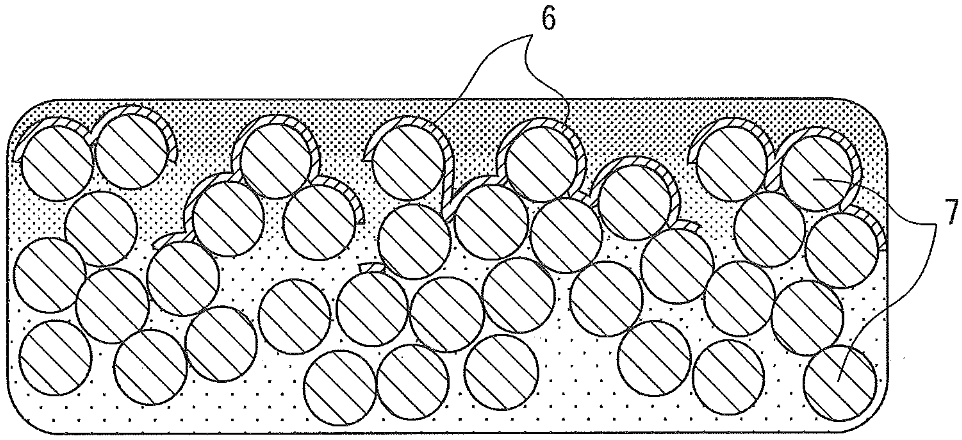


FIG. 5

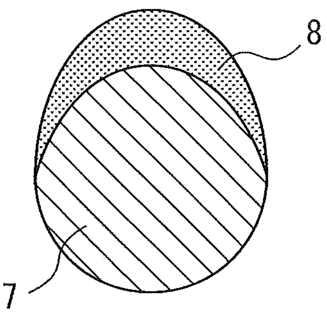


FIG. 6

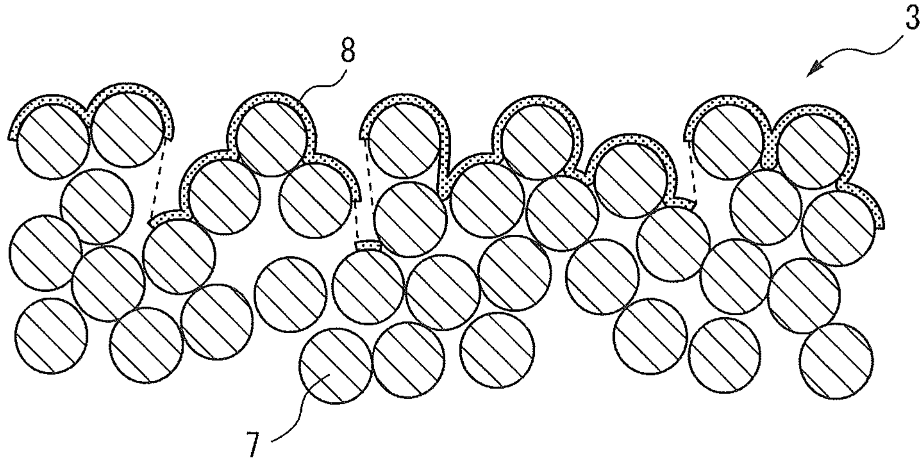

FIG. 7

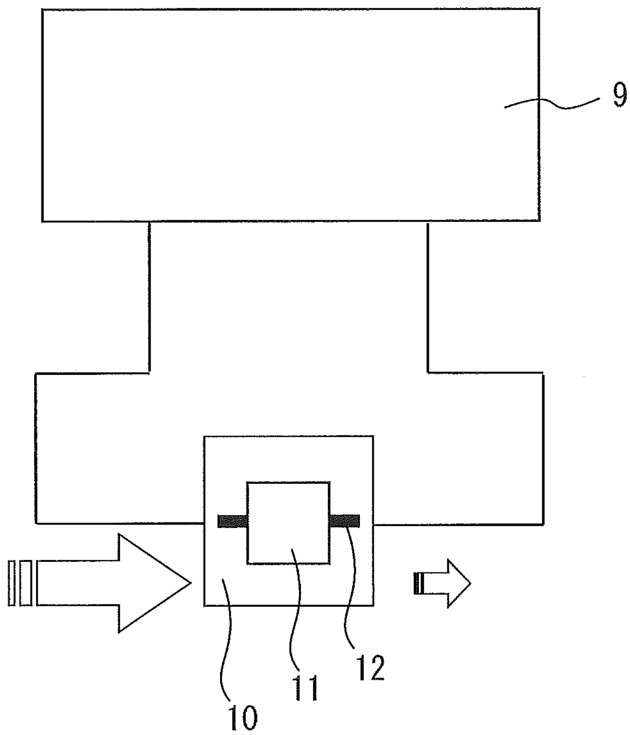


FIG. 8

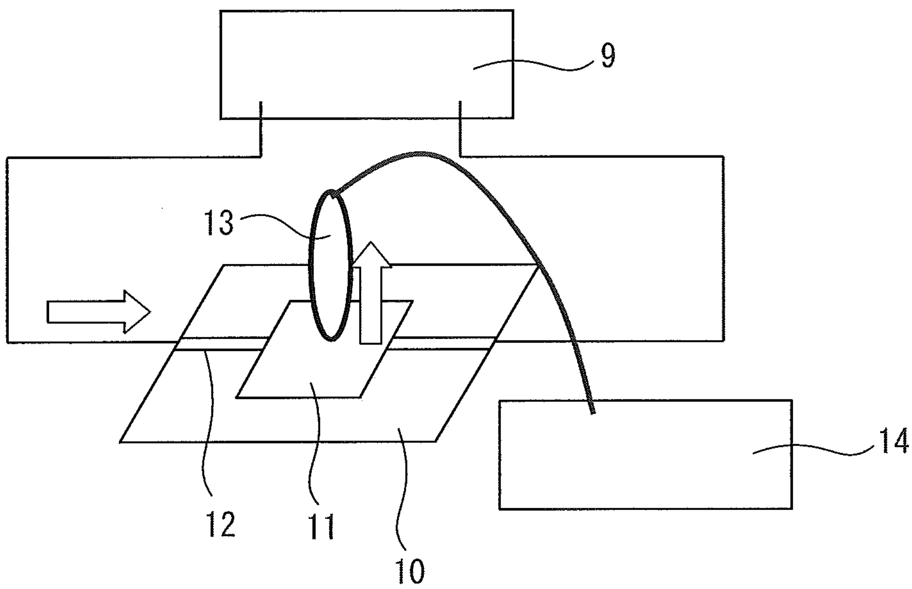

FIG. 9

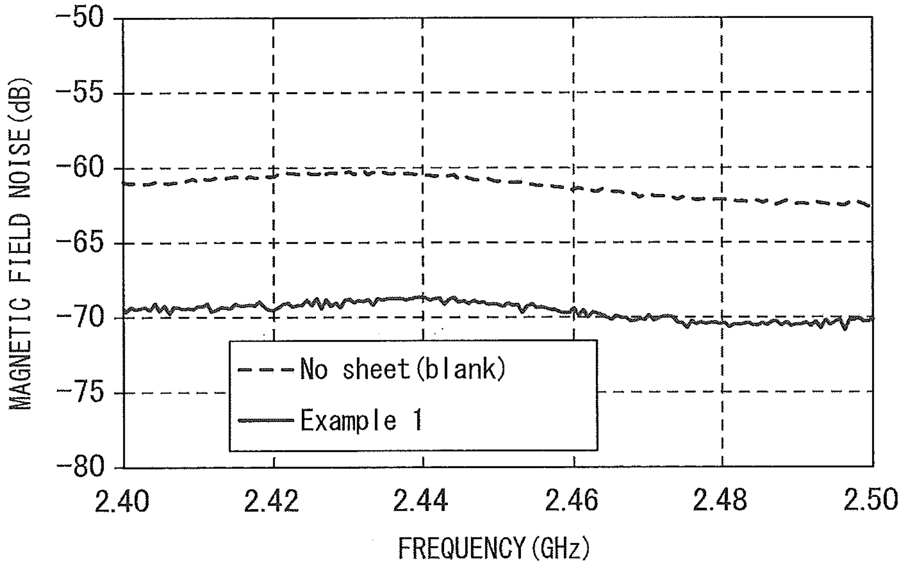
-50
-55
-60
-65
-70
-75
-80
MAGNETIC FIELD NOISE (dB)
No sheet (blank)
Example 1
2.40
2.42
2.44
2.46
2.48
2.50
FREQUENCY (GHz)

FIG. 10

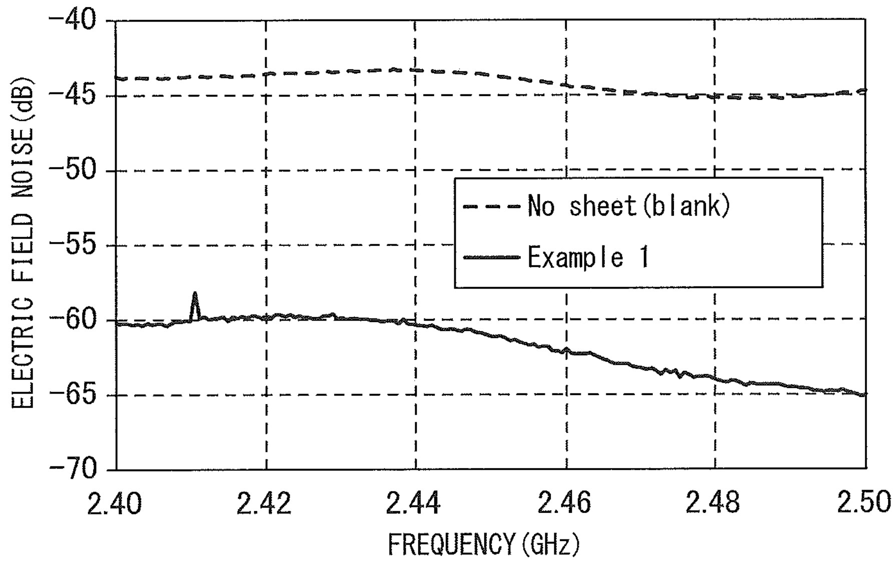
-40
-45
-50
-55
-60
-65
-70
ELECTRIC FIELD NOISE (dB)
No sheet (blank)
Example 1
2.40
2.42
2.44
2.46
2.48
2.50
FREQUENCY (GHz)

FIG. 11

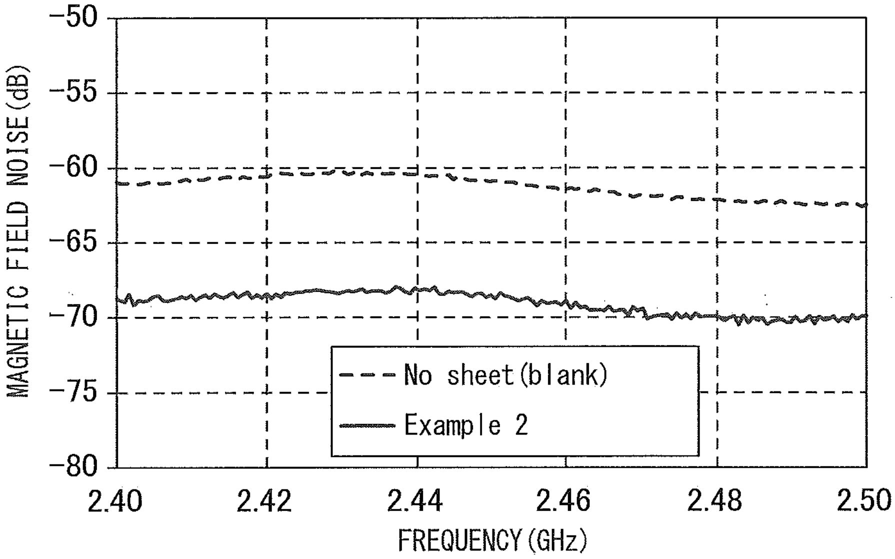
-50
-55
-60
-65
-70
-75
-80
MAGNETIC FIELD NOISE (dB)
2.40
2.42
2.44
2.46
2.48
2.50
FREQUENCY (GHz)
No sheet (blank)
Example 2

FIG. 12

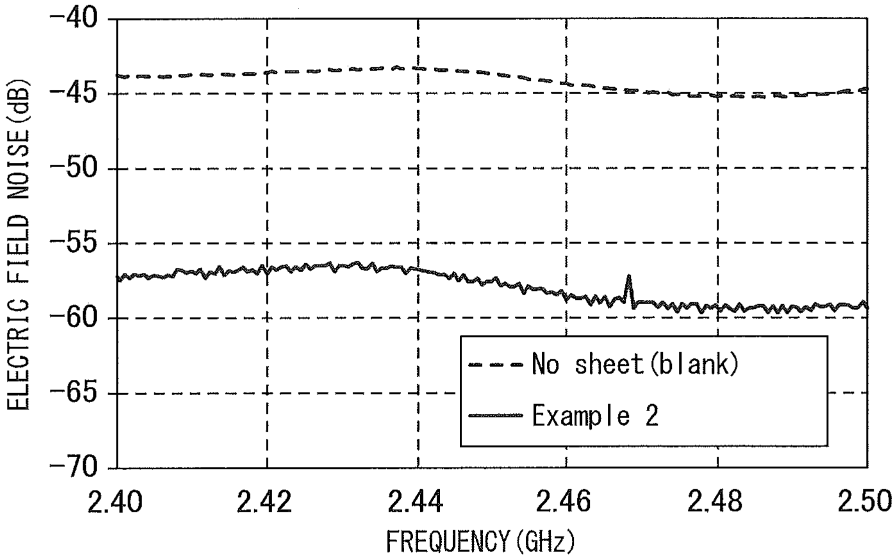
-40
-45
-50
-55
-60
-65
-70
ELECTRIC FIELD NOISE (dB)
2.40
2.42
2.44
2.46
2.48
2.50
FREQUENCY (GHz)
No sheet (blank)
Example 2

FIG. 13

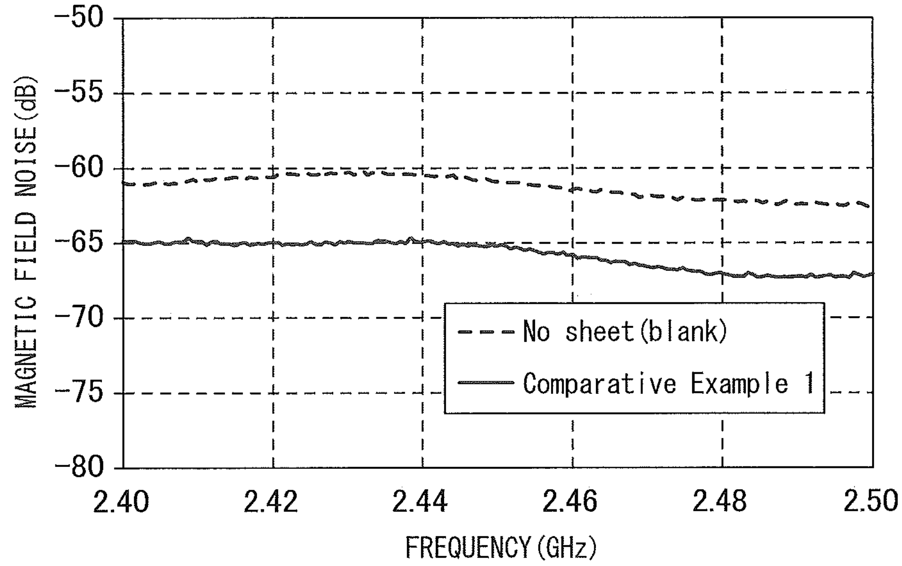
-50
-55
-60
-65
-70
-75
-80
MAGNETIC FIELD NOISE (dB)
2.40
2.42
2.44
2.46
2.48
2.50
FREQUENCY (GHz)
No sheet (blank)
Comparative Example 1

FIG. 14

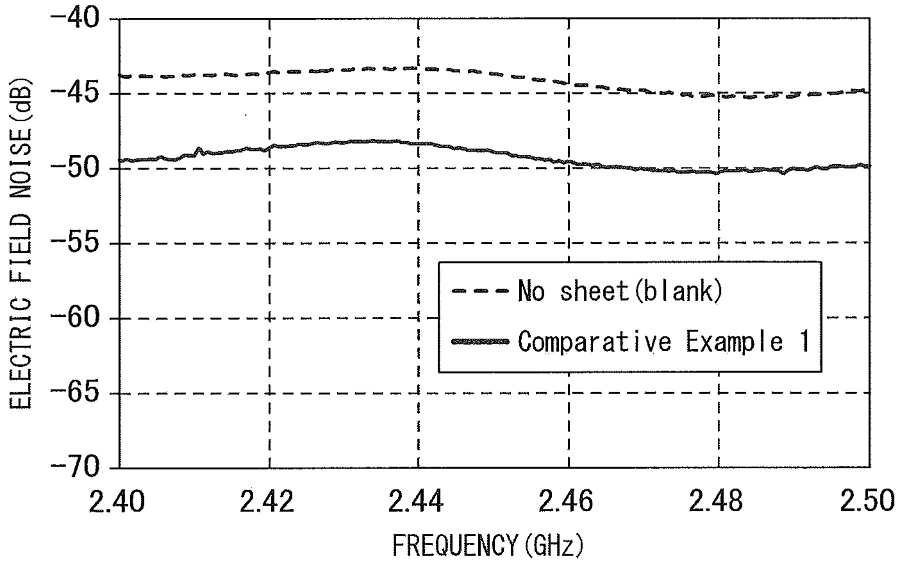
-40
-45
-50
-55
-60
-65
-70
ELECTRIC FIELD NOISE (dB)
2.40
2.42
2.44
2.46
2.48
2.50
FREQUENCY (GHz)
No sheet (blank)
Comparative Example 1

FIG. 15

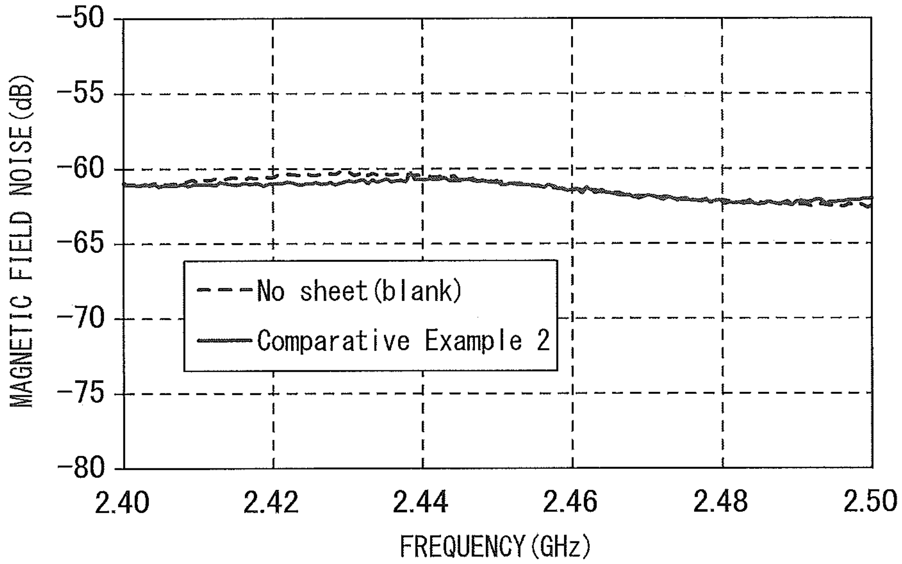
-50
-55
-60
-65
-70
-75
-80
MAGNETIC FIELD NOISE (dB)
2.40
2.42
2.44
2.46
2.48
2.50
FREQUENCY (GHz)
No sheet (blank)
Comparative Example 2

FIG. 16

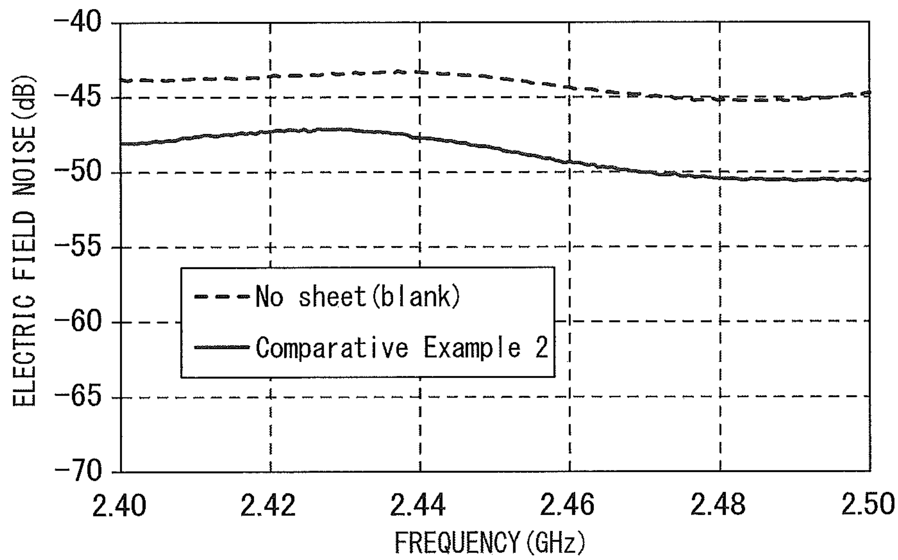
-40
-45
-50
-55
-60
-65
-70
ELECTRIC FIELD NOISE (dB)
2.40
2.42
2.44
2.46
2.48
2.50
FREQUENCY (GHz)
No sheet (blank)
Comparative Example 2

FIG. 17

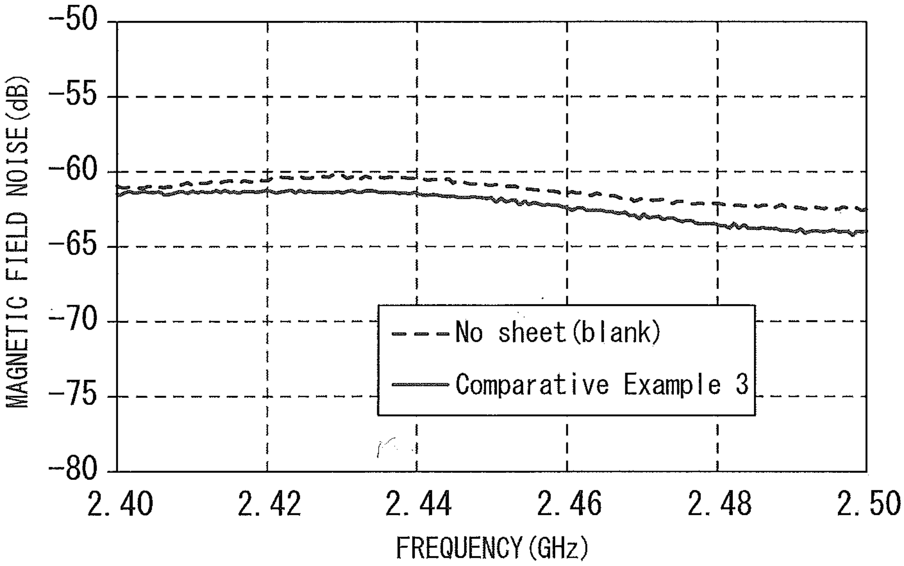
-50
-55
-60
-65
-70
-75
-80
MAGNETIC FIELD NOISE (dB)
2.40
2.42
2.44
2.46
2.48
2.50
FREQUENCY (GHz)
No sheet (blank)
Comparative Example 3

FIG. 18

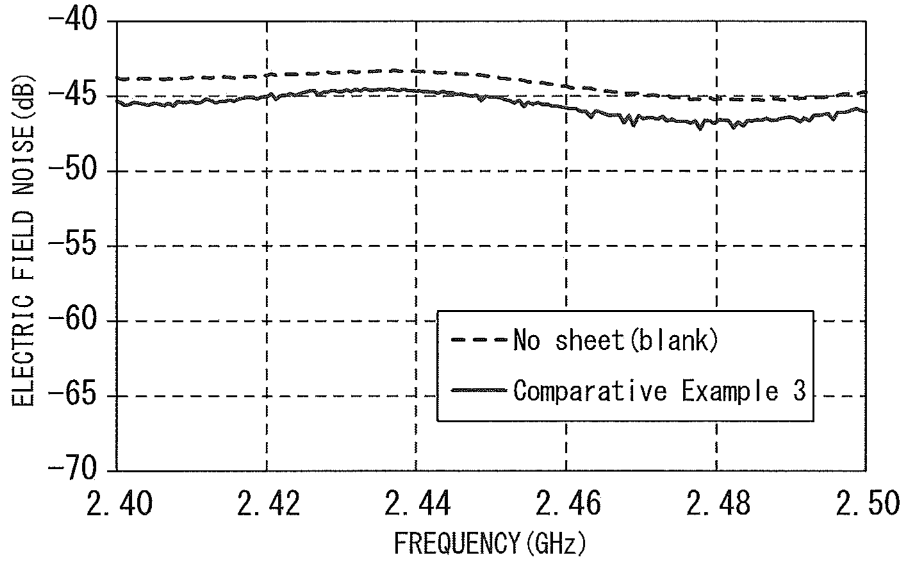
-40
-45
-50
-55
-60
-65
-70
ELECTRIC FIELD NOISE (dB)
2.40
2.42
2.44
2.46
2.48
2.50
FREQUENCY (GHz)
No sheet (blank)
Comparative Example 3

FIG. 19

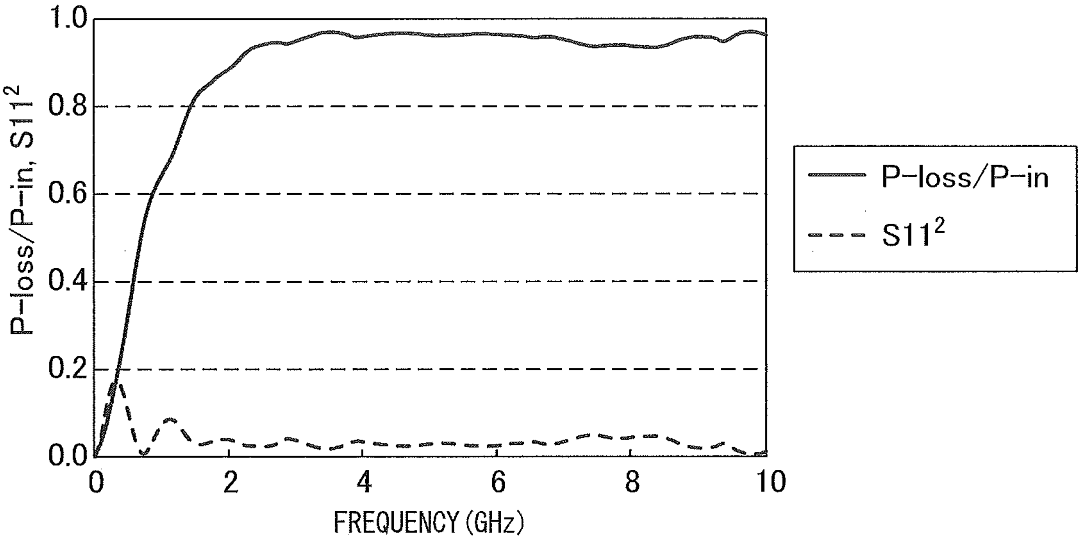
1.0
0.8
0.6
0.4
0.2
0.0
P-loss/P-in, S11²
0
2
4
6
8
10
FREQUENCY (GHz)
P-loss/P-in
S11²

FIG. 20

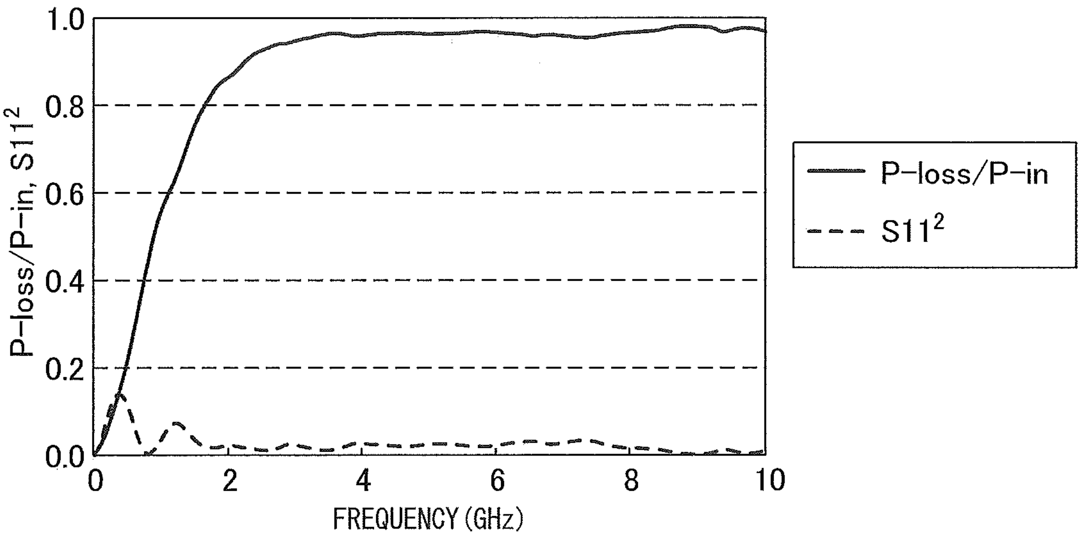
1.0
0.8
0.6
0.4
0.2
0.0
P-loss/P-in, S11²
0
2
4
6
8
10
FREQUENCY (GHz)
P-loss/P-in
S11²

FIG. 21

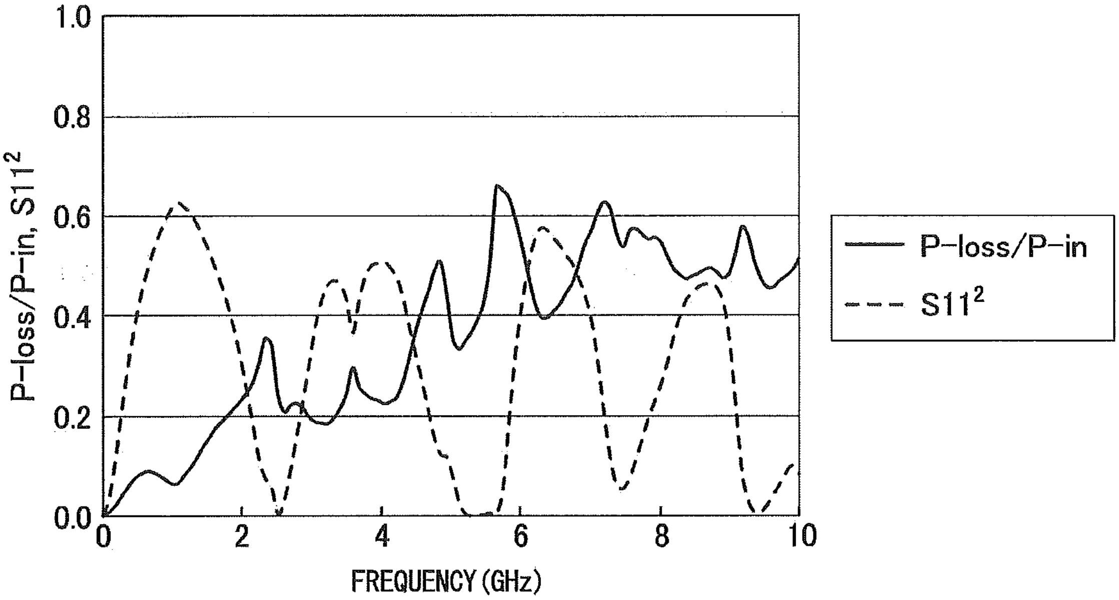
1.0
0.8
0.6
0.4
0.2
0.0
P-loss/P-in, S11²
0
2
4
6
8
10
FREQUENCY (GHz)
P-loss/P-in
S11²

FIG. 22

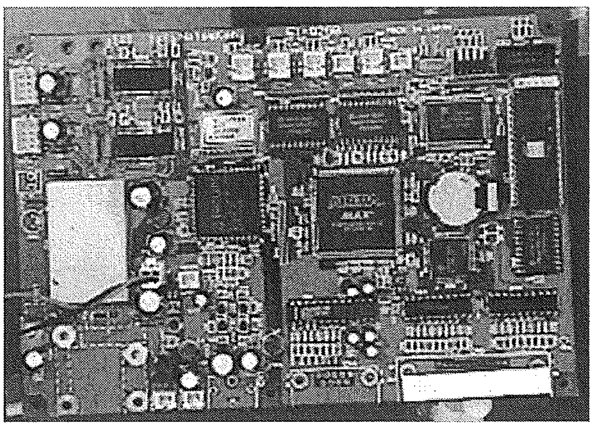

FIG. 23

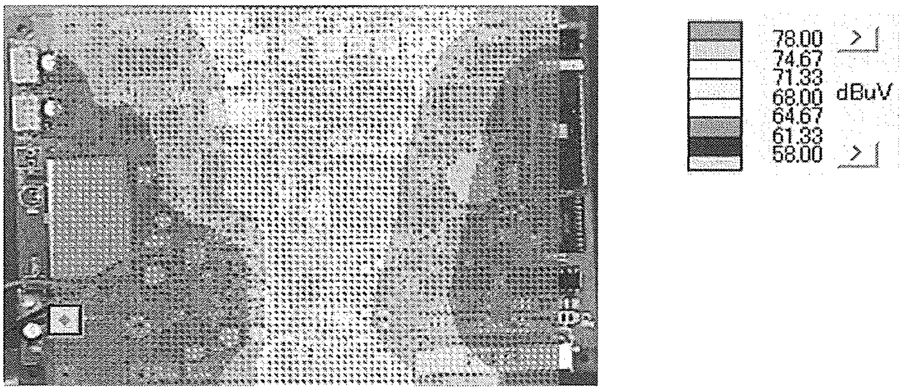
78.00
74.67
71.33
68.00
64.67
61.33
58.00
dBuV

FIG. 24

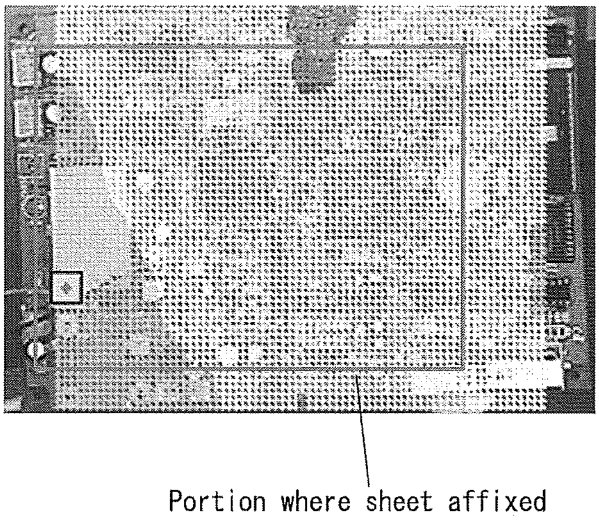
Portion where sheet affixed

FIG. 25

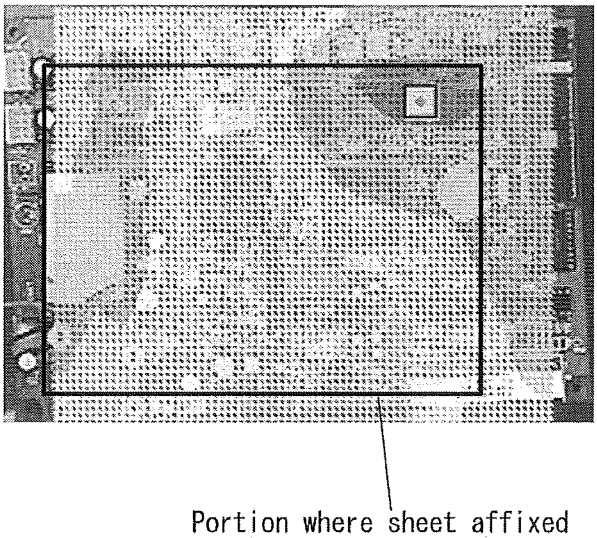

## INTERNATIONAL SEARCH REPORT

International application No.
PCT/JP2014/080963

A. CLASSIFICATION OF SUBJECT MATTER
*H05K9/00*(2006.01)i, *B32B5/08*(2006.01)i, *D04H3/16*(2006.01)i

According to International Patent Classification (IPC) or to both national classification and IPC

B. FIELDS SEARCHED

Minimum documentation searched (classification system followed by classification symbols)
H05K9/00, B32B5/08, D04H3/16

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2011-146696 A (Asahi Kasei Fibers Corp.), 28 July 2011 (28.07.2011), entire text; all drawings<br>& US 2012/0247868 A1 & EP 2515624 A1<br>& WO 2011/074609 A1 & CN 102656962 A<br>& TW 201141367 A & KR 10-2012-0087988 A | 1-8<br>9-13 |
| Y | JP 2013-236064 A (Idemitsu Kosan Co., Ltd.), 21 November 2013 (21.11.2013), paragraphs [0001], [0092], [0097] to [0104]<br>(Family: none) | 9-13 |
| A | JP 2001-284108 A (Tokin Corp.), 12 October 2001 (12.10.2001), entire text; all drawings<br>(Family: none) | 1-13 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 February 2015 (16.02.15) | 24 February 2015 (24.02.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

INTERNATIONAL SEARCH REPORT

International application No.
PCT/JP2014/080963

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-267230 A (Shinshu University), 12 November 2009 (12.11.2009), entire text; all drawings (Family: none) | 1-13 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012028576 A
- JP 2011146696 A
- JP H7212079 B
- JP 2005327853 A
- WO 2013081043 A
- WO 200494136 A
- WO 2010126109 A